(19) Europäisches Patentamt
European Patent Office
Office européen des brevets

(11) EP 1 091 253 B1

(12) **EUROPEAN PATENT SPECIFICATION**

(45) Date of publication and mention of the grant of the patent:
**30.03.2005 Bulletin 2005/13**

(51) Int Cl.[7]: **G03F 7/30**

(21) Application number: **00119423.2**

(22) Date of filing: **13.09.2000**

(54) **Plate making process for planographic plate, automatic developing apparatus and recording medium**

Verfahren zur Flachdruckplattenherstellung, automatische Entwicklungsvorrichtung und Aufzeichnungsmedium

Procédé pour la production de plaques d'impression lithographiques, appareil de développement automatique et support d'enregistrement

(84) Designated Contracting States:
**AT BE CH CY DE DK ES FI FR GB GR IE IT LI LU MC NL PT SE**

(30) Priority: **28.09.1999 JP 27376099**

(43) Date of publication of application:
**11.04.2001 Bulletin 2001/15**

(73) Proprietor: **FUJI PHOTO FILM CO., LTD.**
**Kanagawa 250-01 (JP)**

(72) Inventors:
- **Yoshida, Susumu**
  **Yoshida-cho, Haibara-gun, Shizuoka-ken (JP)**
- **Okuno, Kei**
  **Yoshida-cho, Haibara-gun, Shizuoka-ken (JP)**

(74) Representative: **HOFFMANN - EITLE**
**Patent- und Rechtsanwälte**
**Arabellastrasse 4**
**81925 München (DE)**

(56) References cited:
**GB-A- 1 061 638**
**US-A- 4 537 496**
**US-A- 5 930 547**

- **PATENT ABSTRACTS OF JAPAN vol. 10, no. 127 (P-455), 13 May 1986 (1986-05-13) & JP 60 252351 A (FUJI PHOTO FILM CO., LTD.), 13 December 1985 (1985-12-13)**
- **PATENT ABSTRACTS OF JAPAN vol. 12, no. 390 (P-772), 18 October 1988 (1988-10-18) & JP 63 132242 A (FUJI PHOTO FILM CO., LTD.), 4 June 1988 (1988-06-04)**
- **PATENT ABSTRACTS OF JAPAN vol. 10, no. 135 (P-457), 20 May 1986 (1986-05-20) & JP 60 257449 A (FUJI PHOTO FILM CO., LTD.), 19 December 1985 (1985-12-19)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

BACKGROUND OF THE INVENTION

Field of the Invention

The present invention relates to a plate making process for a planographic plate, and a recording medium. More specifically, the present invention relates to a plate making process for a planographic plate having a photopolymerizable photosensitive layer as a photosensitive layer, and a recording medium.

Description of the Related Art

Generally, a photosensitive planographic plate (hereinafter referred to as "PS plate") is subjected to development processing by a photosensitive planographic plate processing apparatus (hereinafter referred to as "PS plate processor"). In the PS plate processor, development processing is carried out by conveying a PS plate having images recorded thereon into a developing tank so that the PS plate is immersed in the developing solution stored in the developing tank and the photosensitive layer at the non-image portions of the PS plate is removed by a rubbing means such as a rotating brush roller. In this PS plate processor, the PS plate which has been processed with the developing solution is subjected to rinsing with water (water-washing treatment) in a water-washing section, desensitization processing by a gum solution being applied thereto in a desensitizing section, plate surface protection, and the like, in a successive manner.

A problem associated with the above-described process is that it is difficult to maintain the active state of the developing solution at a constant level by carrying out adjustment such that the amount of a replenisher solution and the dilution ratio are always optimal.

That is, generally, a diazo resin layer, a photocrosslinkable type layer , or a photopolymerizable type layer is used as the photosensitive layer of the PS plate. Since the photopolymerizable photosensitive layer is based on radical polymerization, fogging is liable to be caused by scattered light during exposure. The fogging due to scattered light is conspicuous when an inner-drum type apparatus for exposure is used.

The photosensitive layer regions, in which fogging has been caused by diffused light, are somewhat hardened, and therefore, uneven development is caused thereat due to variations in developing temperatures, variations in amounts of replenisher solutions, variations in the conditions of the development accelerating means such as rotating brushes which rub the PS plate in the developing solution so as to accelerate development. Such uneven development lowers the quality of the plate.

Further, since the progress of the deterioration of the developing solution is affected by the thicknesses and types of planographic plates (hereinafter referred to as plate types) and also by the sizes of the exposed areas of the PS plate, it is difficult to maintain the active state of the developing solution at a constant level by carrying out adjustment such that the amount of the replenisher solution and the dilution ratio are always optimal.

Further, conventionally, conditions such as the thickness, size, plate type and the like of the PS plate have been inputted to the PS plate processor manually. Thus, operational errors such as errors in input or failing to input a change or the like have been unavoidable. Even if a single operational error occurs, the PS plate which is the object of development must be discarded and exposure processing must be carried out again, resulting in a great loss of time and resources.

SUMMARY OF THE INVENTION

Accordingly, an object of the present invention is to provide a plate making process for a planographic plate, and a recording medium, which allow the active state of the developing solution, which is filled in a developing tank for a planographic plate, to always be maintained at an optimum level.

An aspect of the plate making process for a planographic plate of the present invention according to claim 1 includes the steps of: (a) exposing a planographic plate, having a photopolymerizable photosensitive layer, in accordance with image data; (b) introducing the planographic plate into a developing tank for developing the planographic plate; (c) determining an amount of replenisher solution to be supplied to the developing tank based on area information of images to be formed and plate information; and (d) supplying replenisher solution to the developing tank in an amount in accordance with the step of determining an amount of replenisher solution, wherein the plate information and the area information of the formed images or the images to be formed comprises at least one of image data to be used in the step of exposing a planographic plate, and low-resolution image data included in print production format data.

In the replenishing step, the amount of the replenisher solution to be replenished is the total of the amount which compensates for the amount of alkali components of the developing solution which has been consumed by the

carbon dioxide gas in the air over time (time-related replenishment) and the amount which compensates for the amount of components which has been consumed by developing processing and which corresponds to the surface area of non-image formed portions (development-related replenishment).

The area information of the images to be formed and the plate information are preferably information which has been obtained or inputted on-line or off-line from a step before the developing step. In this case, the plate information and the area information of the images, which is for calculating the area of non-image formed portions to be removed by the development, are information obtained or inputted on-line or off-line from a step before the developing step. Thus, it is not necessary for a user to input the information, and there are no operational errors such as a user forgetting to make a change or making an error in input.

The replenisher solution amount determining step may be either before or after the exposure step. If the replenisher solution amount determining step is before the exposing step, the step before the developing step is a step selected from a plurality of steps before the exposing step. If the replenisher solution amount determining step is after the exposing step, the step before the developing step is a step selected from a plurality of steps including the exposing step. Further, for example, the area information of the images may be the infomation used in the exposing step. The plate information may be the infomation used in the step before the exposing step. Thus, the area information of the images and the plate information, which are used in separate steps, may be utilized, provided that both have been used in prior steps.

The plate information includes at least one of plate thickness, plate size, and plate type. In the replenisher solution amount determining step, the amount of the replenisher solution to be supplied to the developing tank is determined by the use of the area information of images exposed or to be exposed, and by the use of at least one of the plate thickness, plate size, and plate type included in the plate information.

The following are preferable in the present invention. The plate information includes all of plate thickness, plate size, and plate type, and the concentrations of the developing solution and the replenisher solution are determined by plate type. The surface area of the non-image formed portions of the planographic plate to be actually processed is calculated by the plate size and the surface area of the image formed portions which are derived from the area information of the images to be formed or images which have been formed. The processing replenishment unit amount of the replenisher solution required per unit area is determined by the plate thickness and the plate type. The amount of the replenisher solution is obtained by multiplying the surface area of the non-image formed portions by the processing replenishment unit amount of the replenisher solution. In this way, a more accurate replenishment amount of the replenisher solution can be calculated.

The above-described replenishment amount based on the area information of images may be calculated from actual image data. Alternatively, the above-described replenishment amount may be calculated from low-resolution data which is included in the image data or provided together with the image data. Calculation from low-resolution data is efficient because the image data to be processed, which are low-resolution, place no load on the program, and the time required for the calculation of the image information is shortened. Further, the program itself can be simplified.

As for the timing of adding the replenisher solution, the replenisher solution may be supplied at predetermined intervals. Alternatively, the replenisher solution may be supplied discontinuously such that, when a cumulative added amount of replenishment amounts calculated based on the surface area of the non-image portions exceeds a predetermined amount, the replenisher solution in an amount equivalent to the cumulative added amount is supplied simultaneously with development or after development of the corresponding plate. It is also possible to continuously add the replenishing solution in an amount corresponding to the amount of solution consumed by development and in an amount corresponding to the amount of solution consumed naturally (e.g., by reaction with $CO_2$ in the air) over time. Needless to say, the time-related replenishment may be carried out at intervals of a predetermined time while the development-related replenishment may be carried out as needed.

The above-described plate making process for a planographic plate may include a step in which the concentrations of the developing solution and the replenisher solution are selected based on the plate type included in the plate information, and the dilution ratio of the replenisher solution is determined based on the concentrations, and the replenisher solution is diluted. In this case, an optimum dilution ratio can be selected in accordance with the plate type.

The planographic plate having a photopolymerizable photosensitive layer which is used in the present invention is preferably a photosensitive planographic plate comprising a support having, laminated successively thereon, a photopolymerizable photosensitive layer and a protective layer for the protection of the photosensitive layer.

The above-described plate making process for a planographic plate may include, before the developing step, a heating step in which the planographic plate, on which an image has been exposed, is heated. This heating step makes uniform the surface temperature of the planographic plate before development processing. Accordingly, since nonuniformity of the reaction due to differences in atmosphere and time after exposure can be suppressed, ability of the photosensitive layer to withstand many printings can be improved and dots having uniform sizes can be formed. As a result, a plate of a better image quality is obtained.

As stated above, in the mode of the plate making process for a planographic plate according to the present

invention, since the replenishment amount of the replenisher solution is determined based on the image information of the images to be formed and plate information, the replenisher solution can be supplied in accordance with the development state of the planographic plate being actually processed, or in other words, in accordance with the consumed state of the developing solution during the development processing. As a result, the active state of the developing solution can be maintained at a constant level fairly precisely.

The mode of an automatic developing apparatus for automatic development automatically developing an exposed planographic plate having a photopolymerizable photosensitive layer, by using developing solution and the replenisher solution, the apparatus comprising (a) a developing section for receiving an exposed planographic plate, the developing section having a developing tank for containing developing solution, and a conveying device which conveys the planographic plate in the developing solution; (b) a nozzle system connected to a supply of replenisher solution, electronically operable for supplying replenisher solution into the developing tank; and (c) a control system electronically connected to the nozzle system, the control system including a memory and an electronic logic, the electronic logic causing operation of the nozzle system to supply replenisher solution into the developing tank based on area information of images formed or to be formed and plate information in the control system memory.

That is, in the mode of the automatic developing apparatus for use in the present invention, the replenisher solution amount determining device of the automatic developing apparatus determines the amount of the replenisher solution to be supplied to the developing tank based on the area information of the image to be formed and plate information. Here, the "image to be formed" may be an image which is yet to be formed or an image which has already been formed. Thus, replenisher solution can be supplied in accordance with the consumed state of the developing solution actually consumed by the planographic plates which were developed. As a result, the active state of the developing solution can be maintained at a constant level, and therefore, even fogged portions due to scattered light can be developed satisfactorily, thereby preventing adverse effects on the plate quality.

In addition, since the area information of the images to be formed and plate information which are obtained or inputted on-line or off-line from a step before the developing step are able to be used, it is not necessary for a user to input the area information of images and plate information to the automatic developing apparatus. Operational errors such as a user forgetting to make a change or a user making an error in input do not occur.

The above-mentioned controlling of the amount to be replenished of the replenisher solution is carried out by a replenisher solution amount determining program which, on the basis of the area information of the images and the plate information which are obtained or inputted on-line or off-line from a step before the developing step, determines the amount of the replenisher solution to be supplied to the developing tank, in order to carry out the development processing of a planographic plate which has a photopolymerizable photosensitive layer after exposure, while the plate is being conveyed. This replenisher solution amount determining program may be stored in a recording medium of the automatic developing apparatus in advance, or may be stored in a recording medium which is separate from the automatic developing apparatus and then installed from the recording medium.

The area information of the images and plate information that can be used may be information which is obtained or inputted on-line or off-line from a step before the developing step.

The mode of the recording medium of the present invention is a computer-readable recording medium for use by a computer in controlling a development process as specified in the appended claims, using an apparatus having a developing tank for developing images that have been exposed on a planographic plate having a photopolymerizable photosensitive layer, the development apparatus including an electronic control system for supplying replenisher solution to the developing tank, said computer-readable recording medium comprising electronically readable logic encoded thereon, which when used to program the computer, causes the computer to: (a) determine an amount of replenisher solution to be supplied to the developing tank based on area information of images formed or to be formed on a planographic plate and plate information; and (b) activate the electronic control system to supply replenisher solution to the developing tank in an amount in accordance with the determined amount of replenisher solution.

## BRIEF DESCRIPTION OF THE DRAWINGS

Fig. 1 is a drawing schematically illustrating the flow of the plate making system for use in an embodiment of the present invention.

Fig. 2 is a drawing illustrating the schematic structure of an automatic developing apparatus shown in Fig. 1.

Fig. 3 is a flow chart illustrating the working of a CPU of a processor controlling section shown in Fig. 2.

## DETAILED DESCRIPTION OF THE PREFERRED EMBODIMENTS

Referring now to the drawings, an embodiment of the present invention will be explained in detail. In the

present embodiment, a case is explained in which the present invention is applied to a plate making system, formed by a personal computer 10, a work station 12, a plate setter (exposure device) 14, and a PS plate processor (automatic developing apparatus) 16, as shown in Fig. 1.

The photosensitive planographic plate to be used in the present embodiment (hereinafter referred to as "PS plate") may be a structure in which an organic undercoat layer, a photopolymerizable photosensitive layer, and an overcoat layer are provided in that order on the surface of an aluminum support on whose reverse surface a backcoat layer is provided. Details of the PS plate are described later.

In the plate making system for use according to the present embodiment, the personal computer 10, the work station 12, the plate setter 14, and the PS plate processor 16 are all connected on-line. Various setting information, such as image data, plate thickness, plate sizes, and plate type, which have been inputted to the personal computer 10, can be outputted on-line to the PS processor 16.

An application which allows, for example, the editing of images, which have been read by an image reading means such as a scanner, while the images are shown on a display, or allows the production of new letters or images on the display so that images for prints are formed, is installed in the personal computer 10.

The application outputs to the workstation 12 the images produced by a user as vector-type image data such as drawing commands indicating, for example, the outline, the area ratio of filling portions, and the transmissivity of filling portions of the images. In addition, the application outputs to the workstation 12, together with the above-mentioned vector-type image data, various setting information, such as the plate type of the PS plate to be exposed, the plate thickness, and the plate size, which have been inputted from the keyboard by a user concurrently with the image formation, and PPF (Print Production Format) data. The PPF is a standard format which is the main format of CIP 3 (International Cooperation for Integration of Prepress, Press and Postpress), and is a common format which is in compliance with international standards and includes low-resolution image data (area information of images), transfer characteristic curves of films and plates, data of types and positions of register marks, color density information for quality control, and information about cutting and register marks for cutting.

A raster image processor (hereinafter referred to as RIP) and a driver software for the plate setter 14 are installed in the workstation 12.

RIP is a program which interprets vector-type image data and translates them into an array of dots having a gradation and which is an application capable of converting the vector-type image data into raster-type image data such as a TIFF-type file (hereinafter referred to as a TIFF file) or a GIF file. In the present embodiment, vector-type image data is converted into a TIFF file comprised of a tag-type header portion and an image data portion.

The driver software of the plate setter 14 is a software which converts the TIFF file, the above-mentioned setting information, and the PPF data into an image format which can be analyzed by the plate setter 14 and outputs the image format to the plate setter 14.

Accordingly, the workstation 12 converts the vector-type image data such as an drawing command outputted from the personal computer 10 into a TIFF file. Thereafter, the driver software of the plate setter 14 converts the TIFF file and the various setting information into an image format which can be analyzed by the plate setter 14. Thereafter, the driver software of the plate setter 14 outputs the converted TIFF file and setting information together with the PPF data to the plate setter 14.

The plate setter 14 includes a setter controlling section 18 comprised of a ROM, a RAM, and a CPU. The ROM stores programs for controlling the plate setter 14, while the RAM temporarily stores the TIFF file in an image format analyzable by the plate setter 14, the various setting information, and the PPF data.

The CPU calls various programs from the ROM. On the basis of the TIFF file, the various setting information, and PPF data, read from the ROM, the CPU, by using the programs, generates various types of control signals such as, for example, a control signal for controlling the conveying speed of a conveying means (not shown) of the plate setter 14, an on/off driving signal for a laser light source (not shown), a laser driving signal for adjusting the light amount, and the like. The CPU carries out driving control of the plate setter 14 by these various control signals. In this way, the plate setter 14 carries out the exposure processing of a PS plate 110 under optimum conditions in accordance with the image selected on the personal computer 10.

The plate setter 14 is preferably, for example, an inner-drum type plate setter using a semiconductor laser emitting rays ranging from ultraviolet to visible light (360 nm to 450 nm). The semiconductor laser of the inner-drum type plate setter is preferably, for example, an InGaN semiconductor laser. Such a structure brings about the advantage that the amount of exposure can be increased while minimizing the occurrence of fogging even when an inner-drum type plate setter is used, and therefore, the ability of the photosensitive layer to withstand many printings can be improved.

Although the reason for this is not clear, it can be presumed to be as follows. The portion of the laser light in excess of the amount of laser light absorbed by the photosensitive layer of the PS plate is released as reflected light from the PS plate surface. The longer the wavelength of the reflected light, the higher the regular reflectance will be. The shorter the wavelength of the reflected light, the smaller the regular reflectance will be because of scattering.

Therefore, use of an inner-drum type plate setter using a semiconductor laser emitting rays ranging from ultraviolet to visible light (360 nm to 450 nm) is believed to reduce the regular reflectance and suppresses the occurrence of fogging due to regularly reflected light.

Needless to say, the present invention is not limited to the use of plate-making systems comprising an inner-drum type plate setter, and another exposure means, such as an extra-drum (outer-drum) type plate setter or a flat-bed type plate setter, may be employed. Further, since exposure by means of the plate setter 14 is conventionally known, detailed explanation thereof is omitted.

A driver software for the PS plate processor 16 is installed in the ROM of the setter controlling section 18 so that the various setting information, such as the plate type, the plate thickness, and the plate size, are outputted, together with the PPF data, to the PS plate processor 16 after the driver software for the PS plate processor 16 has converted the setting information into a format analyzable by the PS plate processor 16.

As shown in Fig. 2, the PS processor 16 is roughly divided into a heating section 20, a first water-washing section 22, a developing section 24, a second water-washing section 26, a finisher section 28, a drying section 29, and a processor controlling section 30. A PS plate is conveyed by means of conveying mechanism comprised of a plurality of pairs of conveying rollers successively to the heating section 20, the first water-washing section 22, the developing section 24, the second water-washing section 26, the finisher section 28, and the drying section 29.

The heating section 20 includes a pair of pull-in rollers 31, to which the driving force of a driving means (not shown) is transmitted, and a heating device 32. The pair of pull-in rollers 31, which nip the PS plate 110 after exposure and rotate so as to convey the PS plate 110 in the conveying direction thereof, pull the PS plate 110 into the interior of the PS processor 16. The heating device 32 heats the PS plate 110 which has been pulled into the interior of the PS processor 16.

The heating of the PS plate 110 before development processing accelerates the hardening of the image formed portions (i.e., exposed regions) in the photopolymerizable photosensitive layer of the PS plate 110. In the present embodiment, the various setting information for determining the heating conditions of the heating section 20 are also obtained on-line from a step before the developing step and are temporarily stored in the RAM. Then, the driving voltage of the heater is controlled based on the stored various setting information.

In this way the surface temperature of the PS plate can be made uniform under heating conditions optimal to the combination of plate type, plate thickness, and plate size, regardless of the temperature of the inside of the exposing section of the plate setter 14 and the temperature of the PS plate 110 before being thermally treated. As a result, problems, such as insufficient heat treatment or excessive heat treatment, can be obviated and good heat treatment can be carried out. In addition, since the user does not need to input the various setting information, loss of time and resources due to, for example, operational errors can be avoided. Further, since the changeover to the subsequent heating conditions can be performed efficiently, the processing efficiency from exposure to development can be inproved.

The PS plate 110, after being thermally treated in the heating section 20, is conveyed to a first water-washing section 22 which follows the heating section 20.

As shown in Fig. 2, the first water-washing section 22 has a first water-washing tank 60 equipped with a pair of pull-in rollers 62, a first water supply nozzle 64a, a first rotating brush roller 66, a backup roller 67, a second water supply nozzle 64b, a third water supply nozzle 64c, a transfer roller 68, and a pair of delivery rollers 72, provided in that order from the upstream side along the conveying direction of the PS plate 110. The overcoat layer present on the uppermost surface of the PS plate 110 is removed by the water-washing before development.

In addition, the first water-washing tank 60 is equipped with a first overflow pipe 61 which effects adjustment such that a constant amount of washing water is always kept in the first washing tank 60 by allowing the washing water in the first washing tank 60 to flow into the first overflow pipe 61 and to reach a water circulating tank 63 when the surface level of the washing water in the first washing tank 60 exceeds a predetermined level.

The water circulating tank 63 is equipped with a pump P which draws the water up and supplies the water to the first water supply nozzle 64a and to the second water supply nozzle 64b.

A third water supply nozzle 64c supplies the water, which is drawn up by a water replenishing pump P3 from a water tank 84 storing clean washing water, to the first water-washing tank 60 so that a constant level of cleanliness of the washing water in the first washing tank 60 is maintained. The driving of the water replenishing pump P3 is controlled by the processor controlling section 30.

Washing water is supplied from the first water supply nozzle 64a to the surface of the PS plate 110 which has been heated and which has been pulled into the first water-washing section 22 by the pull-in rollers 62. When the PS plate 110 in this state is nipped and conveyed between the first rotating brush roller 66 and the backup roller 67, the surface of the PS plate 110 is abraded by the first rotating brush roller 66 such that the overcoat layer, which is the topmost layer of the PS plate 110, is removed.

After the first rotating brush roller 66, there is provided the second water supply nozzle 64b for supplying washing water to the surface of the PS plate 110 so that the scum of the overcoat layer remaining on the surface of

the PS plate 110 after the use of the first rotating brush roller 66 is removed. By this treatment, the overcoat layer is removed from the surface of the PS plate 110. The PS plate is transferred from the conveying roller 68 to the pair of delivery rollers 72. Next, the PS plate 110 is fed into the developing section 24 which is provided after the first water-washing section 22.

As shown in Fig. 2, the developing section 24 has a developing tank 70 equipped with an undiluted development replenisher solution spray nozzle 74, a dilution water spray nozzle 76, a first spray pipe 78, a second rotating brush roller 71a, a third rotating brush roller 71b, and a pair of delivery rollers 75, provided in that order from the upstream side along the conveying direction of the PS plate 110. The PS plate 110 is immersed in the developing solution and is subjected to development processing.

The PS plate 110, which is delivered by the pair of delivery rollers 72 of the first water-washing section 22, is pulled into the developing section 24 at an angle between about 15° and 31° with respect to the horizontal direction. The undiluted development replenisher solution spray nozzle 74 sprays the developing solution, which is drawn up by a development replenisher solution supply pump P1 from a developing solution storing tank 82, into the inside of the developing tank 70. The driving of the development replenisher solution supply pump P1 is controlled by the processor controlling section 30 which is described later.

Similarly, the dilution water spray nozzle 76 sprays the dilution water, which is drawn up by a water replenishing pump P2 from a water-storing tank 84, into the inside of the developing tank 70. The driving of the water replenishing pump P2 is also controlled by the processor controlling section 30.

The processor controlling section 30 comprises a CPU, a ROM, and a RAM. The RAM temporarily stores various setting information and PPF data. The ROM stores a replenisher solution amount determining program which calculates the surface area of the non-image formed portions from the low-resolution image data included in the PPF data and plate sizes, determines the amount of the replenisher solution to be supplied to the developing tank by using the surface area of the non-image formed portions obtained by the calculation and the plate information, and generates control signals for the undiluted development replenisher solution supply pump P1 and the water supply pump P2, respectively, so that the replenishment amount is supplied. In this case, the surface area of the non-image formed portions is obtained by subtracting the surface area of the image formed portions from the surface area at which image formation is possible and which is derived from the plate size.

Further, the ROM stores a processing replenishment unit amount (i.e., replenisher solution amount per 1 $m^2$ of the planographic plate to be developed) which is determined in accordance with the plate type included among the various setting information.

The CPU calls up the replenisher solution amount determining program stored in the ROM, and the CPU performs the following operations. First, the CPU determines the dilution ratio of the undiluted development replenisher solution on the basis of the plate type included in the various setting information stored in the RAM. Then, in order to achieve the determined dilution ratio, The CPU determines the ratio of the flow rate of the water replenishing pump P2 to the flow rate of the replenishing pump P1 for a unit time. Next, based on the surface area of the non-image formed portions and the processing replenishment unit amount, The CPU calculates a processing replenishment amount and adds this amount to the amount obtained by the preceding calculation so as to cumulatively add up the calculated processing replenishment amounts. When the cumulative processing replenishment amount exceeds a predetermined amount, the replenishing pump P1 and the water replenishing pump P2 are driven so that replenisher solution in the amount equivalent to the amount obtained by the cumulative addition is supplied into the developing tank 70.

For example, if the proportion of the non-image portions is large, the rate of deterioration of the developing solution is proportionally higher, and therefore the amount of the replenisher solution to be supplied is increased. On the other hand, if the proportion of the non-image portions is small, the rate of deterioration of the developing solution is proportionally lower, and therefore the amount of the replenisher solution to be supplied is decreased.

For example, the case of photopolymer type plate for CTP, which is now in general use, is explained. LP-D (trade name; manufactured by Fuji Photo Film Co, Ltd; a developing solution for DIGITAL PLATE) is diluted 10-fold and the diluted solution is charged into the developing tank 70 as a developing solution. In order for LP-DR (trade name; manufactured by Fuji Photo Film Co, Ltd; a development replenisher solution for DIGITAL PLATE) to be supplied to the developing tank 70 in a 5-fold diluted solution as a replenisher solution, the flow rate ratio between the development replenisher solution supply pump P1 and the water supply pump P2 is adjusted. That is, the driving of the development replenisher solution supply pump P1 and the water supply pump P2 is controlled such that the ratio of the flow rate of the development replenisher solution supply pump P1 to the flow rate of the water supply pump P2 is 1:4.

Although here, the flow rate ratio between the development replenisher solution supply pump P1 and the water supply pump P2 is adjusted so that a replenisher solution, which is obtained by 5-fold dilution of the undiluted development replenisher solution, is supplied to the developing tank 70, the dilution ratio varies in accordance with the plate type. For example, the undiluted development replenisher solution may be diluted 4-fold to obtain a replenisher solution for a plate type X, while the undiluted development replenisher solution may be diluted 3-fold to obtain a replenisher solution for a plate type Y.

After the adjustment of the dilution ratio of the undiluted development replenisher solution by the two pumps P1 and P2, the amount of the development replenisher solution to be supplied to the developing tank 70 is determined based on the surface area of non-image formed portions, plate information, and the amount of the alkali components in the replenisher solution to be consumed by carbon dioxide gas in the air.

For example, an area of non-image formed portions is calculated by subtracting an area of image formed portions based on image area information, from an area of image formable portions based on a plate size which is included in plate information. The replenisher solution unit amount required per unit area is determined on the basis of the plate type. In the case of plate type A, the replenisher solution unit amount in the developing processing is 75 $cm^3/m^2$. The area of the non-image formed portions is multiplied by the replenisher solution unit amount required per unit area, so as to calculate the replenisher solution amount consumed by development. The replenisher solution amount required to replenish the consumed amount of alkaline components by carbon dioxide gas in the air during operation (e.g., 100 $cm^3$ per hour) is added to the replenisher solution amount consumed by development and the replenisher solution amount is determined. The replenisher solution is replenished in an amount of the determined replenisher solution amount by controlling the total flow amounts of the two pumps P1, P2.

While the development is stopped, since the apparatus is in a state in which no development processing is carried out and therefore the surface area of the non-image formed portions is zero, the total of the flow rates of the two pumps P1 and P2 is controlled so that the replenisher solution amount is equivalent to the replenisher solution amount required for compensating for the consumed amount of the alkali components during the period of stoppage (i.e., 80 $cm^3$/hour).

The processing replenishment unit amount varies in accordance with the plate type and is, for example, 75 $cm^3/m^2$ for the plate type A and 100 $cm^3/m^2$ for the plate type B, when the dilution ratio of the undiluted development replenisher solution is 5-fold. Therefore, even if the surface area of the non-image formed portions is the same, the replenisher solution amount which is required varies in accordance with the plate type.

Now, referring to the flowchart of Fig. 3, the control to be executed by the CPU of the processor controlling section 30 will be explained. At step 300, judgement as to whether the PS plate processor 16 is operating or not is made. If the PS plate processor 16 is judged to be operating, the process moves to step 302 where various setting information and PPF data are read from the RAM.

At step 304, the surface area of the non-image formed portions is determined from the low-resolution image data included in the PPF data and the plate size included in the various setting information which are read out from the RAM. At step 306, the corresponding processing replenishment unit amount is read from the ROM on the basis of the plate type included in the various setting information.

At step 308, the processing replenishment amount is calculated by multiplying the surface area of the non-image formed portions obtained at step 304 by the processing replenishment unit amount read at the step 306. At step 310, the calculated processing replenishment amount is added.

At step 312, a judgement is made as to whether the added amount of the processing replenishment amounts exceeds a pre-determined amount or not. If the amount is judged as exceeding the pre-determined amount, the replenisher solution is supplied in an amount equivalent to the added amount of the processing replenishing amounts. Thereafter, the routine moves to step 316. On the other hand, at the step 312, if the amount is judged as not exceeding the predetermined amount, the routine moves to step 322 and a judgement is made as to whether a pre-determined time has passed or not.

If it is judged that the pre-determined time has passed, the routine moves to step 324 and the replenisher solution is supplied in an amount equivalent to the replenisher solution amount required for compensating for the consumed amount of the alkali components during the operation of the PS plate processor 16. Thereafter, the process moves on to step 316. On the other hand, if it is judged that the pre-determined time has not passed, the routine returns to step 308, and the above-described processes are repeated.

Meanwhile, at the step 300, if it is judged that the PS plate processor 16 not operating, the routine moves to step 318, and a judgement is made as to whether a pre-determined time has passed or not. If is judged that the pre-determined time has passed, the routine moves on to step 320 and the replenisher solution is supplied in an amount equivalent to the replenisher solution amount required for compensating for the consumed amount of the alkali components during the stopping of the PS plate processor 16. Thereafter, the routine moves on to step 316.

At step 316, a judgement is made as to whether the operation of the PS plate processor 16 has stopped or not. If the operation is judged as not having stopped, the routine returns to the step 302 and the above-described processes are repeated. On the other hand, if it is judged that operation has stopped, the present routine ends. The replenishing of the replenisher solution can be carried out by controlling the driving of the development replenisher solution supply pump P1 and the water supply pump P2 so that a corresponding amount of the replenisher solution is supplied to the developing tank 70.

Here, an aspect is described in which the total replenished amount of the undiluted replenishing solution and water is adjusted on the basis of the magnitude and the like of the area of the non-image portions. However, it is

possible to adjust the concentration of the replenishing solution by adjusting the proportion of the amount of the undiluted replenishing solution with respect to water, on the basis of the magnitude or the like of the area of the non-image portions.

Inside the developing tank 70, there is provided a second overflow pipe 79 which recovers the developing solution which has over flown from the developing tank 70. If the liquid surface level of the developing solution in the developing tank 70 exceeds a pre-determined level, the developing solution flows into the second overflow pipe 79 and is guided to a waste liquid tank 80. In this way, the amount of the developing solution in the developing tank 70 is adjusted so that a constant amount of the developing solution is always maintained.

The developing solution for use in the present invention contains the following components.

(Alkali agents)

The developing solution and the development replenisher solution for use in the development method of the present invention are alkali aqueous solutions having a pH value of 9.0 to 13.5 and more preferably 10.0 to 13.3.

Conventionally known alkali aqueous solutions may be used as the developing solution and the development replenisher solution. Examples include inorganic alkali agents such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium bicarbonate, potassium bicarbonate, ammonium bicarbonate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide, and lithium hydroxide. Other examples are organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

Among these alkali agents, examples of particularly preferred agents are aqueous solutions of a silicate such as sodium silicate or potassium silicate. This is because the adjustment of pH or developability is possible by varying the ratio of silicon oxide $SiO_2$ to alkali metal oxide $M_2O$, which are components of the silicate (this ratio is generally expressed in an $[SiO_2]/[M_2O]$ molar ratio), or the concentration of these components. For example, suitably used in the present invention is an alkali metal silicate such as an aqueous solution of sodium silicate which has an $SiO_2/Na_2O$ molar ratio of 1.0 to 1.5 (i.e., $[SiO_2]$ / $[Na_2O]$ is 1.0 to 1.5) and whose $SiO_2$ content is 1 to 4% by weight.

Examples of other preferred alkali agents include buffer solutions composed of weak acids and strong bases. The weak acid to be used in these buffer solutions is preferably a weak acid having an acid dissociation constant (pKa) of 10.0 to 13.3, and a pKa of 11.0 to 13.1 is particulaly preferable. For example, sulfosalicylic acid, whose third dissociation constant is 11.7, is suitably used in the present invention. That is, in the case of a polybasic acid, if at least one of the acid dissociation constants is within the above-mentioned range, the polybasic acid can be used in the present invention.

These weak acids are selected from those described, for example, in IONISATION CONSTANTS OF ORGANIC ACIDS IN AQUEOUS SOLUTION, published by Pergamon Press Co., Ltd. Examples of the weak acid include alcohols such as 2,2,3,3-tetrafluoropropanol-1 (pKa:12.74), trifluoroethanol (pKa:12.37), and trichloroethanol (pKa:12.24); aldehydes such as pyridine-2-aldehyde (pKa:12.68) and pyridine-4-aldehyde (pKa:12.05); saccharides such as sorbitol (pKa:13.0), saccharose (pKa:12.7), 2-deoxyribose (pKa:12.61), 2-deoxyglucose (pKa:12.51), glucose (pKa:12.46), galactose (pKa:12.35), arabinose (pKa:12.34), xylose (pKa:12.29), fructose (pKa:12.27), ribose (pKa:12.22), mannose (pKa:12.08), and L-ascorbic acid (pKa:11.34); compounds having a phenolic hydroxyl group such as salicylic acid (pKa:13.0), 3-hydroxy-2-naphthoic acid (pKa:12.84), catechol (pKa:12.6), gallic acid (pKa:12.4), sulfosalicylic acid (pKa:11.7), 3,4-dihydroxysulfonic acid (pKa:12.2), 3,4-dihydroxybenzoic acid (pKa:11.94), 1,2,4-trihydroxybenzene (pKa:11.82), hydroquinone (pKa:11.56), pyrogallol (pKa:11.34), and resorcinol (pKa:11.27); oximes such as 2-butanone oxime (pKa:12.45), acetoxime (pKa:12.42), 1,2-cycloheptane dioxime (pKa:12.3), 2-hydroxy benzaldehyde oxime (pKa:12.10), dimethylglyoxime (pKa:11.9), ethanediamide dioxime (pKa:11.37), and acetophenone oxime (pKa:11.35); amino acids such as 2-quinolone (pKa:11.76), 2-pyridone (pKa:11.65), 4-quinolone (pKa:11.28), 4-pyridone (pKa:11.12), 5-aminovaleric acid (pKa:10.77), 2-mercaptoquinoline (pKa:10.25), and 3-amino propionic acid (pKa:10.24); nucleic acids-related substances such as fluorouracil (pKa:13.0), guanosine (pKa:12.6), uridine (pKa:12.6), adenosine (pKa:12.56), inosine (pKa:12.5), guanine (pKa:12.3), cytidine (pKa:12.2), cytosine (pKa:12.2), hypoxanthine (pKa:12.1), and xanthine (pKa:11.9); and other weak acids such as diethylaminomethylsulfonic acid (pKa:12.32), 1-amino-3,3,3-trifluorobenzoic acid (pKa:12.29), isopropylidenediphosphonic acid (pKa:12.10), 1,1-ethylidenediphosphonic acid (pKa:11.54), 1,1-ethylidenediphosphonic acid-1-hydroxy (pKa:11.52), benzimidazole (pKa:12.86), thiobenzamide (pKa:12.8), picoline thioamide (pKa:12.55), and barbituric acid (pKa:12.5).

Examples of the strong bases to be used in combination with these weak acids include sodium hydroxide, ammonium hydroxide, potassium hydroxide and lithium hydroxide.

These alkali agents may be used singly or in combinations of two or more.
Among these alkali buffer agents, preferable are combinations of, on the one hand, sulfosalicylic acid, salicylic acid, saccharose, or sorbitol, and, on the other hand, sodium hydroxide or potassium hydroxide. Particularly preferable combinations are sorbitol and potassium hydroxide or sodium hydroxide.
When the above-mentioned alkali agents are used, the pH is adjusted to within a preferable range depending on the concentrations and combinations.

(Surfactants)

If necessary, for acceleration of the developability, improvement of the dispersion of the scum from development, and enhancement of the affinity to ink of image portions of plates, various surfactants or organic solvents may be added to the developing solutions and replenisher solutions used in the present invention. Preferred examples of surfactants include anionic surfactants, cationic surfactants, nonionic surfactants, and amphoteric surfactants.
Preferred examples of surfactants include nonionic surfactants such as polyoxyethylene alkyl ethers, polyoxyethylene alkylphenyl ethers, polyoxyethylene polystyrylphenyl ethers, polyoxyethylenepolyoxypropylene alkyl ethers, fatty acid partial esters of glycerin, fatty acid partial esters of sorbitan, fatty acid partial esters of pentaerythritol, fatty acid monoesters of propylene glycol, fatty acid partial esters of sugar, fatty acid partial esters of polyoxyethylene sorbitan, fatty acid partial esters of polyoxyethylene sorbitol, fatty acid esters of polyethylene glycol, fatty acid partial esters of polyglycerin, polyoxyethylene-modified castor oils, fatty acid partial esters of polyoxyethylene/glycerin, diethanol amides of fatty acids, N,N-bis-2-hydroxyalkylamines, polyoxyethylenealkylamines, fatty acid esters of triethanolamines, and trialkylamine oxides; anionic surfactants such as fatty acid salts, abietic acid salts, hydroxyalkanesulfonic acid salts, alkanesulfonic acid salts, dialkylsulfosuccinic acid ester salts, straight-chain alkylbenzenesulfonic acid salts, branched-chain alkylbenzenesulfonic acid salts, alkylnaphthalenesulfonic acid salts, alkylphenoxypolyoxyethylenepropylsulfonic acid salts, polyoxyethylene alkylsulfophenyl ether salts, sodium salt of N-methyl-N-oleyltaurine, secondary sodium salt of N-alkylsulfosuccinic acid monoamide, salts of petroleum-derived sulfonic acids, sulfated tallow oil, salts of sulfuric acid ester of fatty acid alkyl esters, salts of sulfuric acid alkyl ester, salts of sulfuric acid ester of polyoxyethylene alkyl ether, salts of sulfuric acid ester of fatty acid monoglyceride, salts of sulfuric acid ester of polyoxyethylene alkylphenyl ether, salts of sulfuric acid ester of polyoxyethylene styrylphenyl ether, salts of phosphoric acid alkyl ester, salts of phosphoric acid ester of polyoxyethylene alkyl ether, salts of phosphoric acid ester of polyoxyethylene alkylphenyl ether, partial saponification products of styrene/maleic anhydride copolymers, partial saponification products of olefin/maleic anhydride copolymers, and formalin condensation products of naphthalene sulfonic acid salts; cationic surfactants such as salts of alkylamines, tertiary ammonium salts, e.g., tetrabutylammonium bromide, salts of polyoxyethylenealkylamine, and polyethylenepolyamine derivatives; and amphoteric surfactants such as carboxybetaines, aminocarboxylic acids, sulfobetaines, amino sulfate esters, and imidazolines. Among the above-listed surfactants, "polyoxyethylene" can be read as "polyoxyalkylene" such as polyoxymethylene, polyoxypropylene, polyoxybutylene, and the like. Therefore, such surfactants are also included.
Other preferred surfactants are a fluorine-containing surfactants having in the molecule thereof a perfluoroalkyl group. Examples of such fluorine-containing surfactants include anionic types such as salts of perfluoroalkylcarboxylic acid, salts of perfluoroalkylsulfonic acid, and salts of perfluoroalkylphosphoric acid; amphoteric types such as perfluoroalkylbetaine; cationic types such as perfluoroalkyl trimethylammonium salt; and nonionic types such as perfluoroalkylamine oxide, perfluoroalkylethylene oxide addition products, oligomers containing a perfluoroalkyl group and a hydrophilic group, oligomers containing a perfluoroalkyl group and a lipophilic group, oligomers containing a perfluoroalkyl group, a hydrophilic group, and a lipophilic group, and urethanes containing a perfluoroalkyl group and a lipophilic group.
The above-listed surfactants may be used singly or in combinations of two or more types. The amounts of these surfactants added to the developing solution range from 0.001 to 10% by weight, and preferably from 0.01 to 5% by weight.

(Development-stabilizing agents)

Various development-stabilizing agents are used in the developing solutions and replenisher solutions used in the present invention. Preferred examples of the development-stabilizing agents include the polyethylene glycol addition products of alcohols derived from saccharide described in Japanese Patent Application Laid-Open (JP-A) No. 6-282079, tetraalkylammonium salts such as tetrabutylammonium hydroxide, phosphonium salts such as tetrabutylphosphonium bromide, and iodonium salts such as diphenyliodonium chloride.
Other examples include the anionic surfactants or amphoteric surfactants described in JP-A No. 50-51324, the water-soluble cationic polymers described in JP-A No. 55-95946, and the water-soluble, amphoteric polymeric electrolytes described in JP-A No. 56-142528.

Still other examples include the organoboron compounds added with alkylene glycol described in JP-A No. 59-84241, the water-soluble surfactants based on a polyoxyethylene/polyoxypropylene block polymer described in JP-A No. 60-111246, the polyoxyethylene/polyoxypropylene-substituted alkylenediamine compounds described in JP-A No. 60-129750, polyethylene glycols having a weight average molecular weight of 300 or more described in JP-A No. 61-215554, fluorine-containing surfactants having a cationic group described in JP-A No. 63-175858, and the water-soluble ethylene oxide addition products obtained by adding 4 moles or more of ethylene oxide to an acid or alcohol and the water-soluble polyalkylene compounds described in JP-A No. 2-39157.

(Organic solvents)

If necessary, an organic solvent is added to the developing solution or the development replenisher solution. An organic solvent, whose solubility in water is about 10% by weight or less and preferably 5% by weight or less, is suitable as the organic solvent. Examples of the organic solvent include 1-phenylethanol, 2-phenylethanol, 3-phenyl-1-propanol, 4-phenyl-1-butanol, 4-phenyl-2-butanol, 2-phenyl-1-butanol, 2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamine, and N-phenyldiethanolamine. The content of the organic solvent is 0.1 to 5% by weight based on the total weight of the liquid to be used. The amount to be used of the organic solvent is closely related to the amount to be used of the surfactant. As the amount of the organic solvent increases, the amount of the surfactant is preferably increased. This is because, if the amount of the surfactant is small while a large amount of the organic solvent is used, the organic solvent is not completely dissolved, and therefore, if may not be possible to ensure.

(Reducing agents)

Further, a reducing agent is added to the developing solution and the replenisher solution used in the present invention. The purpose of adding the reducing agent is to prevent the smudging of the printing plate. The addition of a reducing agent is particularly effective when an negative-type photosensitive planographic plate, which contains a photosensitive diazonium compound, is developed. Preferred examples of the reducing agents include phenolic compounds such as thiosalicylic acid, hydroquinone, menthol, methoxyquinone, resorcinol, and 2-methylresorcinol; and amine compounds such as phenylenediamine and phenylhydrazine. In addition, preferred examples of the inorganic reducing agents include sodium, potassium, or ammonium salts of inorganic acids such as phosphorous acid, hydrogensulfurous acid, phosphorous acid, hydrogenphosphorous acid, dihydrogenphosphorous acid, thiosulfuric acid, and dithionous acid. Among these reducing agents, sulfites provide particularly excellent smudge-preventing effects. These reducing agents are used in a range of 0.05 to 5% by weight based on the developing solution which is used.

(Organic carboxylic acids)

An organic carboxylic acid may be added to the developing solution and the replenisher solution used in the present invention. Preferred organic carboxylic acids are aliphatic carboxylic acids and aromatic carboxylic acids having, respectively, 6 to 20 carbon atoms. Specific examples of the aliphatic carboxylic acid include caproic acid, enanthic acid, caprylic acid, lauric acid, myristic acid, palmitic acid, and stearic acid. Among these acids, an alkanic acid having 8 to 12 carbon atoms is particularly preferable. These aliphatic carboxylic acids may be unsaturated fatty acids having a double bond in the carbon chain, or may be acids having a branched carbon chain.

Aromatic carboxylic acids are compounds having a carboxyl group substituted on a benzene ring, naphthalene ring, anthracene ring, or the like. Specific examples of the aromatic carboxylic acid include o-chlorobenzoic acid, p-chlorobenzoic acid, o-hydroxybenzoic acid, p-hydroxybenzoic acid, o-aminobenzoic acid, p-aminobenzoic acid, 2,4-dihydroxybenzoic acid, 2,5-dihydroxybenzoic acid, 2,6-dihydroxybenzoic acid, 2,3-dihydroxybenzoic acid, 3,5-dihydroxybenzoic acid, gallic acid, 1-hydroxy-2-naphthoic acid, 3-hydroxy-2-naphthoic acid, 2-hydroxy-1-naphthoic acid, 1-naphthoic acid, and 2-naphthoic acid. Among these acids, hydroxynaphthoic acid is particularly effective.

The above-mentioned aliphatic carboxylic acids and aromatic carboxylic acids are preferably used in the form of sodium, potassium, or ammonium salts so as to increase the water-solubility of the acids. Although the content of the organic carboxylic acid in the developing solution used in the present invention is not particularly limited, sufficient effects cannot be obtained if the content is less than 0.1% by weight. On the other hand, a content of 10% by weight or more brings about no further enhancement of the effect and may adversely affect the dissolution of other additives when other additives are also used. Accordingly, the organic carboxylic acids are used preferably in a range of 0.1 to 10% by weight, more preferably in a range of 0.5 to 4% by weight, based on the developing solution which is used.

(Others)

In necessary, a defoaming agent, a hard water softening agent, or the like may be included in the developing solution and the replenisher solution used in the present invention. Examples of the hard water softening agent include polyphosphoric acid, and sodium, potassium, or ammonium salts thereof; aminopolycarbonxylic acids such as ethylenediaminetetraacetic acid, diethylenetriaminepentaacetic acid, triethylenetetraaminehexaacetic acid, hydroxyethylethylenediaminetriacetic acid, nitrilotriacetic acid, 1,2-diaminocyclohexanetetraacetic acid, and 1,3-diamino-2-propanoltetraacetic acid, and sodium, potassium, or ammonium salts thereof; and aminotri(methylenephosphonic acid), ethylenediaminetetra(methylenephosphonic acid), diethylenetriaminepenta(methylenephosphonic acid), triethylenetetraminehexa(methylenephosphonic acid), hydroxyethylethylenediaminetri(methylenephosphonic acid), 1-hydroxyethane-1,1-diphosphonic acid, and sodium, potassium, or ammonium salts thereof.

Although the optimum amount of the hard water softening agent varies with the chelating force thereof and the hardness and the amount of the hard water to be used, generally, the amount of the hard water softening agent is in a range of 0.01 to 5% by weight, preferably in a range of 0.01 to 0.5% by weight, based on the developing solution used. If the amount to be added is less than this range, the expected objects are not sufficiently achieved, whereas if the amount to be added is greater than this range, adverse effects such as voids of color are caused at the image portions.

Water, which forms the remainder of the developing solution and the replenisher solution used in the present invention, may contain various additives known in the art, if necessary.

From the standpoint of transportation, it advantageous to ship the developing solution and the replenisher solution used in the present invention as concentrated solutions which are to be diluted with water when used. A proper concentration is a concentration at which no separation or deposition of the components occurs.

The temperature of the developing solution is preferably 15 to 40°C and more preferably 20 to 35°C. The time for development is preferably 5 to 60 seconds and more preferably 7 to 40 seconds.

In the developing section 24, a solution surface cover 73 is provided on the surface of the developing solution. The solution surface cover 73.is provided such that the lower surface thereof is positioned beneath the surface of the developing solution stored in the developing tank 70. The presence of the solution surface cover 73 diminishes the contact surface area between the surface of the developing solution in the developing tank 70 and the air so that the deterioration of the developing solution by the carbon dioxide gas in the air and the evaporation of water from the developing solution are suppressed.

In the developing solution inside the developing tank 70, there is provided a guide plate 77 whose central bottom portion protrudes downward and whose inner surface is substantially in the shape of an inverted mountain. The guide plate 77 has a structure in which a plurality of small, freely-rotating rollers (not shown) are disposed in parallel in such a way that the axes of rotation thereof are at a right angle to the conveying direction of the PS plate 110, so that the PS plate 110 which has entered into the developing section 24 is conveyed while being guided by the small rollers. In this case, since the small rollers rotate, the PS plate 110 is not scratched as may otherwise occur were the PS plate 110 to slide.

A first spray pipe 78 is disposed in the developing solution on the way to the lowest position of the guide plate 77. The first spray pipe 78 is formed by a plurality of spray pipes, which are arranged at a right angle to the conveying direction of the PS plate 110. The first spray pipe 78 serves to accelerate the development processing of the PS plate 110 by spraying the developing solution from each spray pipe onto the surface of the PS plate 110, and to circulate the developing solution in the developing tank 70.

In addition, from the lowest position of the guide plate 77 along the downstream direction, at the position facing the upper surface of the PS plate 110, there are provided a second rotating brush roller 71a and a third rotating brush roller 71b which are driven, respectively, by a driving means (not shown) and rotate in the conveying direction of the PS plate 110.

In the final section of the developing section 24, there is provided a pair of delivery rollers 75 whose nip is positioned above the surface of the developing solution. The pair of delivery rollers 75 feeds the PS plate 110, which has been conveyed along the guide plate 77 provided in the developing solution, out from the developing section 24 while the PS plate 110 is nipped between the delivery rollers 75. At this time, the developing solution adhering to the surface of the PS plate 110 is squeezed out.

That is, the PS plate 110, which is delivered out from the first water-washing section 22, is pulled by the pair of delivery rollers 72 of the first water-washing section 22 into the developing section 24 at an angle between about 15° and 31 with respect to the horizontal direction, and the PS plate 110 is conveyed along the surface of the guide plate 77 provided in the developing solution. At this time, the PS plate 110 is immersed in the developing solution, and the unexposed portions of the photopolymerizable photosensitive layer are reliably made to swell (i.e., developed) by the developing solution sprayed from the first spray pipe 78 provided on the way to the lowest position of the guide plate 77.

On the way to the downstream side from the lowest position of the guide plate 77, the surface of the PS plate 110 is rubbed by the second rotating brush roller 71a and thereafter by the third rotating brush roller 71b so that the unexposed portions of the photopolymerizable photosensitive layer are rubbed off. Further, when the PS plate 110 is nipped between the pair of delivery rollers 75 from the final position of the guide plate 77 so as to be pulled out of the developing solution and then fed out by the delivery rollers 75, the developing solution adhering to the front and back surfaces of the PS plate 110 is squeezed out. The PS plate 110 is then delivered to a second water-washing section 26 provided at a position subsequent to the developing section 24.

As shown in Fig. 2, the second water-washing section 26 is equipped with a second water-washing tank 90, two pairs of transfer rollers 92 and 94, a second spray pipe 96, and a third spray pipe 98. The second water-washing section 26 rinses the PS plate 110, which has undergone development processing, with washing water so that the developing solution adhering to the PS plate 110 is completely removed.

The two pairs of transfer rollers 92 and 94 are provided above the second water-washing tank 90 and at a pull-in position and a delivery position for the PS plate 110, respectively, in the second water-washing section 26. The two pairs of transfer rollers 92 and 94 form the conveying path of the PS plate 110 and rotate by being driven by a driving means (not shown) so that the PS plate 110 delivered from the developing section 24 is conveyed in a nipped state.

Between the two pairs of transfer rollers 92 and 94, a second spray pipe 96 and a third spray pipe 98 are provided at positions beneath and above the conveying path of the PS plate 110, respectively.

The second spray pipe 96 supplies water, which is drawn up by the pump P from the water-storing tank 84, to the second water-washing tank 90. The third spray pipe 98 is formed by a plurality of spray pipes which are arranged at a right angle to the conveying direction of the PS plate 110, so that each spray pipe sprays washing water onto the surface of the PS plate 110 along the widthwise direction thereof, synchronously with the conveying of the PS plate 110.

The third spray pipe 98 sprays washing water, which is drawn up by the pump P from a storing tank 93 which will be described later, onto the front face side of the PS plate 110. In this way, the PS plate 110 is rinsed with water and the developing solution is completely removed.

The washing water, which is sprayed from the third spray pipe 98, quickly spreads over the surface of the PS plate 110 and rinses the PS plate 110. The water is squeezed from the PS plate 110 when the PS plate 110 is delivered by the transfer rollers 94 to a finisher section that is the next section.

In addition, the second water-washing tank 90 is equipped with a third overflow pipe 91. The third overflow pipe 91 maintains the water level of the second water-washing tank 90 at a constant level by introducing the washing water, which is flowed into the pipe due to a rise in the water level of the second water-washing tank 90, into the storing tank 93. The storing tank 93 is equipped with a pump P, which draws up the stored washing water and supplies the water to the third spray pipe 98.

That is, the PS plate 110, which is delivered out from the developing section 24, is pulled into the second water-washing section 26 by the pair of delivery rollers 92 provided at the pull-in position of the second water-washing section 26. When the PS plate 110 passes along the conveying path formed above the second water-washing tank, both sides of the PS plate 110 are rinsed with the washing water sprayed from the second spray pipe 96 and the third spray pipe 98. The water adhering to the PS plate 110 is squeezed out therefrom by the pair of delivery rollers 94 provided at the delivery position of the second water-washing section 26. In this way, the PS plate 110 is fed-out from the second water-washing section 26.

After the second water-washing section 26, there is provided the finisher section 28, which is equipped with a gum solution tank 100, a gum solution spray nozzle 102 which sprays a gum solution onto the surface of the PS plate 110, and a pair of transfer rollers 104. In the finisher section 28, the PS plate 110, which has been rinsed with water, is desensitized by the application of the gum solution. Like the other tanks, the gum solution tank is also equipped with an overflow pipe in order to adjust the water level of the tank so that the water level of the tank is maintained at a constant level.

The image-formed side of the PS plate 110, which is delivered out from the second water-washing section 26, is sprayed with the gum solution from the gum solution spray nozzle 102 when the PS plate 110 passes through the finisher section 28. Then, the gum solution adhering to the PS plate 110 is squeezed out therefrom by the pair of delivery rollers 104 provided at the delivery position of the finisher section 28. In this way, the PS plate 110 is delivered out from the finisher section 28.

After the finisher section 28, there is provided a drying section 29. The PS plate 110 is dried while passing through the drying section 29, and thereafter, is delivered to the outside. Since the structure of the drying section 29 may be a conventionally known structure, explanation of the drying section 29 is omitted.

Although any PS plate, which comprises a photopolymerizable photosensitive layer and an overcoat layer (protective layer) protecting the photosensitive layer, may be used in the plate making system of the present embodiment, a preferred PS plate comprises a hydrophilized aluminum plate as a support having thereon a photopolymerizable photosensitive layer containing a compound having an ethylenic double bond and capable of addition polymerization, a photopolymerization initiator activated by light of wavelengths of 450 nm or more, and a polymer having in the side chain thereof a crosslinkable group.

Details of suitable PS plates are given below.

[Aluminum supports]

The aluminum support for the PS plate is a metal formed mainly by dimensionally stable aluminum. That is, the support is made of aluminum or an aluminum alloy. The support is selected from pure aluminum plates, alloy plates containing aluminum as the main component and traces of dissimilar elements, and plastic films or paper which is laminated or vapor-deposited with aluminum (alloy). In addition, the support may be a composite comprising a polyethylene terephthalate film having an aluminum sheet bonded thereon as described in Japanese Patent Application Publication (JP-B) No. 48-18327.

In the following description, the above-described supports made of aluminum or aluminum alloys are collectively called aluminum supports. Examples of the dissimilar elements contained in the aluminum alloy include silicon, iron, manganese, copper, magnesium, chromium, zinc, bismuth, nickel, and titanium. The total content of the dissimilar elements in the alloy is 10% by weight or less. Although pure aluminum is suitable in the present invention, the aluminum which is used may contain traces of dissimilar elements since the production of perfectly pure aluminum is difficult by in view of refining technology. Thus, the composition of the aluminum plate that may be used in the present invention is not specifically defined, and conventionally known aluminum materials, such as materials described in JIS A 1050, JIS A 1100, JIS A 3103, and JIS A 3005, may be suitably selected for use.

The thickness of the aluminum support used in the present invention is approximately 0.1 to 0.6 mm. The thickness may be changed appropriately depending on the sizes of printing machines and the wishes of the user.

[Hydrophilization treatment]

The above-described aluminum support is subjected to a treatment such as graining that is described later, and is thereafter subjected to a hydrophilization treatment by a silicate, polyvinylsulfonic acid, or the like. The amount coated by a hydrophilization treatment as expressed in terms of the amount of Si or P element is 2 to 40 $mg/m^2$ and preferably 4 to 30 $mg/m^2$. The amount coated by a hydrophilization treatment can be measured by fluorescent X-ray analysis.

The hydrophilization treatment is performed by immersing an aluminum support, which has an anodized film formed thereon, in an aqueous solution which has an alkali metal silicate or polyvinylsulfonic acid content of 1 to 30% by weight, preferably 2 to 15% by weight, and a pH value of 10 to 13 at 25°C, for example, for 0.5 to 120 seconds at 15 to 80°C.

Sodium silicate, potassium silicate, lithium silicate, and the like can be used as the alkali metal silicates. Examples of the hydroxide that is used for increasing the pH value of the aqueous solution of alkali metal silicate include sodium hydroxide, potassium hydroxide, lithium hydroxide, and the like.

In addition, the above-mentioned processing solution may contain a salt of an alkaline earth metal or a salt of a metal of group IVB. Examples of the salt of an alkaline earth metal include water-soluble salts such as nitrates, e. g., calcium nitrate, strontium nitrate, magnesium nitrate, and barium nitrate, sulfates, chlorides, phosphates, acetates, oxalates, and borates.

Examples of the salt of a metal of group IVB include titanium tetrachloride, titanium trichloride, titanium potassium fluoride, titanium potassium oxalate, titanium sulfate, titanium tetraiodide, zirconium chloride oxide, zirconium dioxide, zirconium oxychloride, and zirconium tetrachloride.

The salts of an alkaline earth metal or the salts of a metal of group IVB may be used singly or in combinations of two or more types. The amount to be added of these metal salts is preferably in a range of 0.01 to 10% by weight and more preferably in a range of 0.05 to 5.0% by weight.

Further, the silicate electrodeposition described in U. S. Patent No. 3,658,662 is also effective. Furthermore, a surface treatment that is a combination of the electrolytic graining of a support, as described in JP-B No. 46-27481 and JP-A Nos. 52-58602 and 52-30503, plus the above-mentioned anodizing treatment and hydrophilization treatment is also useful.

[Hydrophilic undercoat layer]

If necessary, the following hydrophilic undercoat layer may be provided on the aluminum support which has undergone the above-described silicate treatment.

Also suitable is a support undercoated with a water-soluble resin, such as polyvinylsulfonic acid, a polymer or copolymer having in the side chain thereof a sulfonic acid group, or polyacrylic acid, a water-soluble metal salt (e.

g., zinc borate), a yellow dye, an amine salt, or the like.

Examples of organic compounds that may be used in the organic (resin) undercoat layer are carboxymethyl cellulose; dextrin; gum arabic; phosphonic acids having an amino group such as 2-aminoethylphophonic acid; organic phosphonic acids such as phenylphosphonic acid, naphthylphosphonic acid, alkylphosphonic acid, glycerophosphonic acid, methylenediphosphonic acid, and ethylenediphosphonic acid; organic phosphoric acids such as phenylphosphoric acid, naphthylphosphoric acid, alkylphosphoric acid, and glycerophosphoric acid; organic phosphinic acids such as phenylphosphinic acid, naphthylphosphinic acid, alkylphosphinic acid, and glycerophosphinic acid; amino acids such as glycine and β-alanine; and hydrochlorides of amines having a hydroxyl group such as triethanolamine hydrochloride. The organic phosphonic acids, the organic phosphoric acids, and the organic phosphinic acids may have a substituent. These compounds may be used in combinations of two or more types.

The organic undercoat layer may be formed by any of the following methods. For example, the above-mentioned organic compound is dissolved in water, an organic solvent such as methanol, ethanol, or methyl ethyl ketone, or a mixture thereof to prepare a coating solution, and thereafter the coating solution is coated on an aluminum support to provide a layer which is then dried. Alternatively, the above-mentioned organic compound is dissolved in water, an organic solvent such as methanol, ethanol, or methyl ethyl ketone, or a mixture thereof to prepare a coating solution, and thereafter, an aluminum support is immersed in the coating solution so that the organic compound is adsorbed on the surface of the aluminum support to form a layer which is then rinsed with water or the like and dried. When the former method is employed, a solution containing 0.005 to 10% by weight of the organic compound can be applied by any of various methods. Examples of the methods include bar coating, rotational coating, spraying, and curtain coaxes. When the latter method is employed, the conditions are as follows: the concentration of the organic compound in the solution for the undercoat layer is 0.01 to 20% by weight and preferably 0.05 to 5% by weight; the immersion temperature is 20 to 90°C and preferably 25 to 50°C; and the immersion time is 0.1 seconds to 20 minutes and preferably 2 seconds to 1 minute.

The pH of the coating solution for the undercoat may be adjusted to a value within a range of 1 to 12 by use of a basic substance such as ammonia, triethylamine or potassium hydroxide, or an acidic substance such as hydrochloric acid or phosphoric acid. Further, when a photopolymerizable planographic plate is manufactured, a yellow dye may be incorporated into the coating solution so as to improve the tone reproducibility of the planographic plate.

A suitable coating amount after drying the organic undercoat layer is 2 to 200 $mg/m^2$ and preferably 5 to 100 $mg/m^2$. If the coating amount is less than 2 $mg/m^2$, a sufficient plate life cannot be obtained. The same problem arises if the coating amount is more than 200 $mg/m^2$.

In the surface treatment of the aluminum support, an additional surface treatment such as immersion in an aqueous solution, e.g., an aqueous solution of potassium flurorozirconate, an aqueous solution of a phosphate, or the like, may be carried out.

[Photopolymerizable photosensitive layer]

The main components of the photopolymerizable photosensitive layer used in the present invention are a compound containing an ethylenic double bond and capable of addition polymerization, a photopolymerization initiator, an organic polymeric binder, and others. If necessary, various compounds such as a coloring agent, a plasticizer, a thermal polymerization inhibitor, and the like are added.

The compound containing an ethylenic double bond and capable of addition polymerization is selected arbitrarily from compounds having at least one, and preferably two or more, terminal ethylenically unsaturated bonds.

For example, these compounds are in a chemical form such as a monomer, a prepolymer, i.e., a dimer, trimer, or oligomer, a mixture thereof, or a copolymer thereof.

Examples of the monomer and the copolymer thereof include esters of unsaturated carboxylic acids (e.g., acrylic acid, methacrylic acid, itaconic acid, crotonic acid, isocrotonic acid, maleic acid, and the like) and aliphatic polyhydric alcohol compounds, and amides of unsaturated carboxylic acids and aliphatic polyamine compounds.

Specific examples of the ester monomers of aliphatic polyhydric alcohol compounds and unsaturated carboxylic acids are as follows. Examples of the acrylate include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri (acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomers, and the like.

Examples of the methacrylate include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane, bis[p-(3-methacryloxyethoxy)phenyl]dimethylmethane, and the like.

Examples of the itaconate include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, and the like.

Examples of the crotonate include ethylene glycol dicrotonate, tetramethylene glycol dicrotonate, pentaerythritol dicrotonate, sorbitol tetracrotonate, and the like.

Examples of the isocrotonate include ethylene glycol diisocrotonate, pentaerythritol diisocrotonate, sorbitol tetraisocrotonate, and the like.

Examples of the maleate include ethylene glycol dimaleate, triethylene glycol dimaleate, pentaerythritol dimaleate, sorbitol tetramaleate, and the like.

In addition, mixtures with the above-listed ester monomers may also be used.

Specific examples of the amide monomers made up of aliphatic polyamine compounds and unsaturated carboxylic acids include methylenebis-acrylamide, methylenebismethacrylamide, 1,6-hexamethylenebis-acrylamide, 1,6-hexamethylenebis-methacrylamide, diethylenetriaminetrisacrylamide, xylylenebisacrylamide, xylylenebismethacrylamide, and the like.

Other examples include vinylurethane compounds having in the molecule thereof two or more polymerizable vinyl groups, prepared by adding a hydroxyl group-containing vinyl monomer, which is represented by the following general formula (A), to a polyisocyanate compound having in the molecule thereof two or more isocyanate groups, as described in JP-B No. 48-41 708.

$$CH_2=C(R^5)COOCH_2CH(R^6)OH \qquad (A)$$

wherein $R^5$ and $R^6$ each represents H or $CH_3$.

Further examples of the compound containing an ethylenic double bond and capable of addition polymerization are polyfunctional acrylates and methacrylates such as urethane acrylates described in JP-A No. 51-37193; polyester acrylates described in JP-A No. 48-64183, and JP-B Nos. 49-43191 and 52-30490; and epoxy acrylates prepared by the reaction between epoxy resins and (meth)acrylic acid. In addition, the compounds which are introduced as photo-curable monomers and oligomers in Nihon Sechaku Kyokai Shi (Journal of the Adhesive Society of Japan), Vol. 20 (1984), No. 7, pp. 300-308, can also be used. The amount to be used of these compounds is 5 to 70% by weight (hereinafter abbreviated as %) and preferably 10 to 50% based on the total components.

As for the photopolymerization initiator, any of various photoinitiators conventionally known from patents or literature, or a combination system (photoinitiator system) of two or more photoinitiators, may be selected for use in accordance with the wavelength of the light source to be used.

Various photoinitiator systems have been proposed for cases when visible rays having wavelengths of 450 nm or more, Ar lasers, second higher harmonics of semiconductor laser, or SHG-YAG lasers are used as a light source. Examples of such systems include photo-reducible dyes such as rose bengal, eosin, and erythrosine described in U. S. Patent No. 2,850,445; a combination of a dye and an initiator such as a combination initiator system of a dye and an amine (JP-B No. 44-20189); a combination system of hexaaryl biimidazole, a radical generator, and a dye (JP-B No. 45-37377); a system of hexaaryl biimidazole and p-dialkylaminobenzylidene ketone (JP-B No. 47-2528 and JP-A No. 54-155292); a system of a cyclic cis-$\alpha$-dicarbonyl compound and a dye (JP-A No. 48-84183); a system of a cyclic triazine and a merocyanine dye (JP-A No. 54-151024); a system of 3-ketocoumarin and an activating agent (JP-A Nos. 52-112681 and 58-15503); a system of bimidazole, a styrene derivative, and thiol (JP-A No. 59-140 203); a system of an organic peroxide and a dye (JP-A Nos. 59-1504, 59-140203, 59-189340, and 62-174203, JP-B No. 62-1641, and U. S. Patent No. 4,766,055); a system of a dye and an active halogen compound (JP-A Nos. 63-1718105 and 63-258903); a system of a dye and a borate compound (JP-A Nos. 62-143044, 62-150242, 64-13140, 64-13141, 64-13142, 64-13143, 64-13144, 64-17048, 1-229003, 1-298348, and 1-138204); a system of a dye having a rhodanine ring and a radical generator (JP-A Nos. 2-179643 and 2-244050); a system of titanocene and a 3-ketocoumarin dye (JP-A No. 63-221110); a system of titanocene, a xanthene dye, and an addition-polymerizable, ethylenically unsaturated compound containing an amino or urethane group (JP-A Nos. 4-221958 and 4-219756); a system of titanocene and a specific merocyanine dye (JP-A No. 6-295061); and a system of titanocene and a dye having a benzopyran ring (JP-A No. 8-334897).

The titanocene compound that is used as the photopolymerization initiator in the present invention may be any titanocene compound which, when irradiated with light in the presence of the aforementioned sensitizing dye, can generate active radicals. For example, the titanocene compound for use in the present invention may be selected

appropriately from the conventionally known compounds described in JP-A Nos. 59-152396 and 61-151197.

Specific examples of the titanocene compound include di-cyclopentadienyl-Ti-di-chloride, di-cyclopentadienyl-Ti-bis-phenyl, di-cyclopentadienyl-Ti-bis-2,3,4,5,6-pentafluoropheny-1-yl (hereinafter also referred to as "A-1"), di-cyclopentadienyl-Ti-bis-2,3,5,6-tetrafluoropheny-1-yl, di-cyclopentadienyl-Ti-bis-2,4,6-trifluoropheny-1-yl, di-cyclopentadienyl-Ti-bis-2,6-difluoropheny-1-yl, di-cyclopentadienyl-Ti-bis-2,4-difluoropheny-1-yl, di-methylcyclopentadienyl-Ti-bis-2,3,4,5,6-pentafluoropheny-1-yl (hereinafter also referred to as "A-2"), di-methylcyclopentadienyl-Ti-bis-2,3,5,6-tetrafluoropheny-1-yl, di-methylcyclopentadienyl-Ti-bis-2,4-difluoropheny-1-yl, and bis(cyclopentadienyl)-bis (2, 6-difluoro-3- (pyri-1-yl)phenyl)titanium (hereinafter also referred to as "A-3").

The titanocene compounds used in the photopolymerizable photosensitive layer may be used singly or in combinations of two or more types.

The amount of the photopolymerization initiator to be used is 0.05 to 100 parts by weight, preferably 0.1 to 70 parts by weight, and more preferably 0.2 to 50 parts by weight based on 100 parts by weight of the ethylenically unsaturated compound.

Generally, a photopolymerizable photosensitive layer contains an organic polymer as a binder. In the present invention, the photopolymerizable composition contains an organic polymer having in the side chain thereof a crosslinkable group. The organic polymer (hereinafter simply referred to as polymer) is such that the polymer itself has in the side chain thereof a crosslinkable group (also referred to as an unsaturated group) and a carboxyl group, wherein the crosslinkable group is represented by following general formula [I]

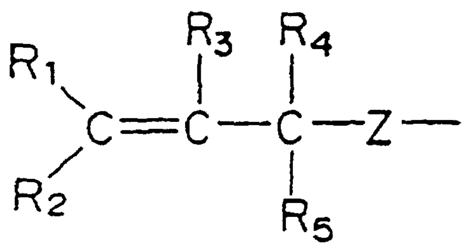

[I]

wherein $R_1$ to $R_5$ are groups selected from halogeno, carboxyl, sulfo, nitro, cyano, amido, amino, alkyl, aryl, alkoxy, aryloxy, alkylamino, arylamino, cycloalkyl, alkylsulfonyl, and arylsulfonyl groups (the alkyl group and groups listed thereafter may have a substituent); and Z is selected from oxygen, sulfur, NH, and NR (where R represents an alkyl group).

Methods for synthesizing the above-described polymer can be broadly classified into the following two methods.

(Method A)

A method in which a crosslinkable group represented by the following formula:

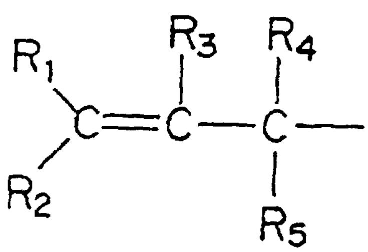

(wherein $R_1$ to $R_5$ are the same as in the general formula [I]) is introduced into a backbone polymer via the linking group -COO-, -COS-, -CONH-, or -CONR- by carrying out a polymer reaction between the backbone polymer, which has as a side chain thereof a carboxylic acid, a carboxylic acid halide, or a carboxylic acid anhydride group, and a compound represented by general formula [I-a] which will be described later.

(Method B)

A method in which a polymer is obtained by carrying out a copolymerization reaction between a monomer, which has a crosslinkable group represented by general formula [I] and an ethylenically unsaturated group having higher addition polymerization reactivity than that of the crosslinkable group, and an unsaturated carboxylic acid.

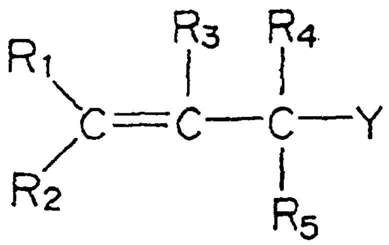

[I-a]

wherein $R_1$ to $R_5$ are the same as in the general formula [I]; and Y represents OH, -SH, $-NH_2$, -NHR (R represents an alkyl group), or a halogen atom.

The alkyl groups represented by $R_1$ to $R_5$ in the general formula [I-a] may be straight-chain, branched, or cyclic alkyl groups preferably having 1 to 7 carbon atoms. These alkyl groups may have substituents such as an alkoxy group having 1 to 2 carbon atoms, an alkoxycarbonyl group having 1 to 3 carbon atoms, a phenyl group, and a hydroxyl group. The aryl groups represented by $R_1$ to $R_5$ are preferably a phenyl group and a furyl group, which groups may have substituents such as a halogeno group (e.g., chloro, bromo, or the like), a hydroxyl group, an alkyl group having 1 to 7 carbon atoms, an aryl group (e.g., phenyl, methoxyphenyl, or the like), an alkoxy group having 1 to 7 carbon atoms, a nitro group, an amino group, and an N,N-dialkylamino group. The alkoxy groups represented by $R_1$ to $R_5$ are preferably alkoxy groups having 1 to 7 carbon atoms. The aryloxy groups represented by $R_1$ to $R_5$ are preferably phenyloxy groups, which may have substituents such as alkyl or alkoxy groups having 1 to 7 carbon atoms. The alkylamino groups represented by $R_1$ to $R_5$ are preferably alkylamino groups having 1 to 15 carbon atoms. The arylamino groups represented by $R_1$ to $R_5$ are preferably phenylamino groups and naphthylamino groups. The alkylsulfonyl groups represented by $R_1$ to $R_5$ are preferably alkylsulfonyl groups having 1 to 15 carbon atoms. The arylsulfonyl groups represented by $R_1$ to $R_5$ are preferably phenylsulfonyl groups and the like, which may have substituents such as an alkyl group having 1 to 15 carbon atoms, an alkoxy group having 1 to 5 carbon atoms, an amino group, and the like.

The details of method A are as follows. Examples of the backbone polymer include a copolymer of acrylic or methacrylic acid or a copolymer which is an acid halide prepared by a polymer reaction from such a copolymer. Other examples include copolymers of maleic anhydride, itaconic anhydride, and the like. Examples of the comonomers for the copolymerization include styrene or an alkyl-substituted derivatives thereof, alkyl esters of acrylic acid, aryl esters of acrylic acid, alkyl esters of methacrylic acid, aryl esters of methacrylic acid, and aliphatic vinyl esters. Preferred examples of the copolymer include copolymers of acrylic or methacrylic acid with methyl acrylate, ethyl acrylate, butyl acrylate, benzyl acrylate, methyl methacrylate, ethyl methacrylate, butyl methacrylate, or benzyl methacrylate. The introduction of the crosslinking group into the copolymer is carried out by dissolving the crosslinkable alcohol, amine, thiol, or halide represented by general formula [I·a] together with the copolymer in a reaction solvent under predetermined reaction conditions, adding a reaction catalyst and a polymerization inhibitor, and heating the resulting reaction solution. More specifically, an example, in which a copolymer of methacrylic acid with benzyl methacrylate is used, is given below.

A 300-mL, three-neck flask fitted with a stirring rod, stirring blade, reflux condenser, and thermometer was charged with 19.8 g of poly(methacrylic acid/benzyl methacrylate) (Wherein the molar ratio of the methacrylic acid to the benzyl methacrylate was 27:73), 40.2 g of ethylene glycol monomethyl ether acetate as a reaction solvent, 6.0 g of allyl bromide as a reagent having a crosslinkable group, 10.4 g of trimethylbenzylammonium hydroxide as a catalyst, and 0.01 g of p-methoxyphenol as a polymerization inhibitor. The contents were mixed and dissolved and stirred for 13 hours at 70°C in a nitrogen atmosphere. After the reaction solution was cooled, methyl ethyl ketone was added to the reaction solution and the liberated quaternary salt was removed. The reaction solution was then diluted with methanol and thereafter poured into a dilute aqueous solution of hydrochloric acid so as to produce a precipitate. The precipitate was washed with water and thereafter collected by filtration under suction. The precipitate was dried under vacuum to obtain the polymer. The yield of the polymer was 13.6 g. The proportion of the allyl group introduced into the backbone polymer was 35%.

$$[\eta]_{30^\circ}^{MEK} = 0.161o$$

The synthesis, in which the crosslinkable group is introduced into a copolymer of maleic anhydride, can be carried out by the method described in U. S. Patent No. 2,047,398, wherein an unsaturated ester, amide, thioester, or the like is introduced by the ring-opening of the maleic anhydride moiety.

Details of method B are as follows. A monomer, which has a crosslinkable group and at least two carbon-carbon double bonds, can be synthesized by carrying out a condensation reaction between an alcohol, amine, or thiol having the crosslinkable group and an unsaturated carboxylic acid, preferably acrylic or methacrylic acid, by a conventionally known synthesis method. By copolymerizing the monomer containing at least two unsaturated groups with an unsaturated carboxylic acid (preferably acrylic or methacrylic acid), a copolymer having the crosslinkable group is obtained. When copolymerized, other monomers may also be copolymerized in addition to the unsaturated carboxylic acid. Examples of the additional monomers include alkyl acrylates, alkyl methacrylates, benzyl methacrylate, 2-hydroxyethyl methacrylate, and acrylonitrile.

An example in which allyl methacrylate is copolymerized with methacrylic acid is given below. A similar synthesis method is described in, for example, U. S. Patent No. 2,047,398.

A 3-L, four-neck flask fitted with a stirring rod, stirring blade, reflux condenser, dropping funnel, and thermometer was charged with 1.68 L of 1,2-dichloroethane as a reaction solvent, and the solvent was heated to 70°C while the atmosphere inside the flask was replaced by nitrogen gas. A solution prepared by dissolving 100.8 g of allyl methacrylate, 7.6 g of methacrylic acid, and 1.68 g of 2,2'-azobis(2,4-dimethylvaleronitrile) as a polymerization initiator in 0.44 L of 1,2-dichloroethane was placed in the dropping funnel, and the solution was added dropwise into the flask, while stirring, over a period of 2 hours.

Upon completion of the dropwise addition, the reaction solution was stirred at 70°C for 5 hours, and thus the reaction was completed. After the heating was stopped, 0.04 g of p-methoxyphenol as a polymerization inhibitor was added to the reaction solution. The solution was then condensed to 500 mL, and the solution thus condensed was added to 4 L of hexane so as to produce a precipitate. After the precipitate was dried under vacuum, 61 g (in 56% yield) of the copolymer was obtained. The viscosity was [η] = 0.068 in methyl ethyl ketone at 80°C.

Representative examples of the compounds represented by general formula [I-a] include allyl alcohol, 2-methylallyl alcohol, crotyl alcohol, 3-chloro-2-propen-1-ol, 3-phenyl-2-propen-1-ol, 3-(hydroxyphenyl)-2-propen-1-ol, 3-(2-hydroxyphenyl)-2-propen-1-ol, 3-(3,4-dihydroxyphenyl)-2-propen-1-ol, 3-(2,4-dihydroxyphenyl)-2-propen-1-ol, 3-(3,4,5-trihydroxyphenyl)-2-propen-1-ol, 3-(3-methoxy-4-hydroxyphenyl)-2-propen-1-ol, 3-(3,4-dihydroxy-5-methoxyphenyl)-2-propen-1-ol, 3-(3,5-dimethoxy-4-hydroxyphenyl)-2-propen-1-ol, 3-(2-hydroxy-4-methylphenyl)-2-propen-1-ol, 3-(4-methoxylphenyl)-2-propen-1-ol, 3-(4-ethoxylphenyl)-2-propen-1-ol, 3-(2-methoxylphenyl)-2-propen-1-ol, 3-(3,4-dimethoxyphenyl)-2-propen-1-ol, 3-(3-methoxy-4-propoxyphenyl)-2-propen-1-ol, 3-(2,4,6-trimethoxyphenyl)-2-propen-1-ol, 3-(3-methoxy-4-benzyloxyphenyl)-2-propen-1-ol, 3-phenoxy-3-phenyl-2-propen-1-ol, 3-(3,4,5-trimethoxyphenyl)-2-propen-1-ol, 3-(4-methylphenyl)-2-propen-1-ol, 3-phenyl-3-(2,4,6-trimethylphenyl)-2-propen-1-ol, 3,3-{di-(2,4,6-trimethylphenyl)}-2-propen-1-ol, 3-phenyl-3-(4-methylphenyl)-2-propen-1-ol, 3,3-diphenyl-2-propen-1-ol, 3-(2-chlorophenyl)-2-propen-1-ol, 3-(3-chlorophenyl)-2-propen-1-ol, 3-(4-chlorophenyl)-2-propen-1-ol, 3-(2,4-dichlorophenyl)-2-propen-1-ol, 3-(2-bromophenyl)-2-propen-1-ol, 3-bromo-3-phenyl-2-propen-1-ol, 3-chloro-3-phenyl-2-propen-1-ol, 3-(4-nitrophenyl)-2-propen-1-ol, 3-(2-nitrophenyl)-2-propen-1-ol, 3-(3-nitrophenyl)-2-propen-1-ol, 2-methyl-3-phenyl-2-propen-1-ol, 2-methyl-3-(4-chlorophenyl)-2-propen-1-ol, 2-methyl-3-(4-nitrophenyl)-2-propen-1-ol, 2-methyl-3-(4-aminophenyl)-2-propen-1-ol, 2-methyl-3,3-diphenyl-2-propen-1-ol, 2-ethyl-1,3-diphenyl-2-propen-1-ol, 2-ethoxymethylene-3-phenyl-2-propen-1-ol, 2-phenoxy-3-phenyl-2-propen-1-ol, 2-methyl-3-(4-methoxyphenyl)-2-propen-1-ol, 2,3-diphenyl-2-propen-1-ol, 1,2,3-triphenyl-2-propen-1-ol, 2,3,3-triphenyl-2-propen-1-ol, 2-ethoxy-3-phenyl-2-propen-1-ol, 1,3-diphenyl-2-propen-1-ol, 1-(4-methylphenyl)-3-phenyl-2-propen-1-ol, 1-phenyl-3-(4-methylphenyl)-2-propen-1-ol, 1-phenyl-3-(4-methoxyphenyl)-2-propen-1-ol, 1-(4-methoxyphenyl)-3-phenyl-2-propen-1-ol, 1,3-di(4-chlorophenyl)-2-propen-1-ol, 1-(4-bromophenyl)-3-phenyl-2-propen-1-ol, 1-pehnyl-3-(4-nitrophenyl)-2-propen-1-ol, 1,3-di(2-nitrophenyl)-2-propen-1-ol, 1-(4-dimethylaminophenyl)-3-phenyl-2-propen-1-ol, 1-phenyl-3-(4-dimethylaminophenyl)-2-propen-1-ol, 1,1-di(4-dimethylaminophenyl)-3-phenyl-2-propen-1-ol, 1,1,3-triphenyl-2-propen-1-ol, 1,1,3,3-tetraphenyl-2-propen-1-ol, 1-(4-methylphenyl)-3-phenyl-2-propen-1-ol, 1-(dodecylsulfonyl)-3-phenyl-2-propen-1-ol, 1-phenyl-2-propen-1-ol, 1,2-diphenyl-2-propen-1-ol, 1-phenyl-2-methyl-2-propen-1-ol, 1-cyclohexyl-2-propen-1-ol, 1-phenoxy-2-propen-1-ol, 2-benzyl-2-propen-1-ol, 1,1-di(4-chlorophenyl)-2-propen-1-ol, 1-carboxy-2-propen-1-ol, 1-carboxyamido-2-propen-1-ol, 1-cyano-2-propen-1-ol, 1-sulfo-2-propen-1-ol, 2-ethoxy-2-propen-1-ol, 2-amino-2-propen-1-ol, 3-(3-amino-4-methoxyphenylsulfonyl)-2-propen-1-ol, 3-(4-methylphenylsulfonyl)-2-propen-1-ol, 3-phenylsulfonyl-2-propen-1-ol, 3-benzylsulfonyl-2-propen-1-ol, 3-anilinosulfonyl-2-propen-1-ol, 3-(4-methoxyanilinosulfonyl)-2-propen-1-ol, 8-anilino-2-propen-1-ol, 3-naphthylamino-2-propen-1-ol, 3-phenoxy-2-propen-1-ol, 3-(2-methylphenyl)-2-propen-1-ol, 3-(3-methylphenoxy)-2-propen-1-ol, 3-(2,4-dimethylphenyl)-2-propen-1-ol, 1-methyl-3-carboxy-2-propen-1-ol, 3-carboxy-2-propen-1-ol, 3-bromo-3-carboxy-2-propen-1-ol, 1-carboxy-3-chloro-3-methyl-2-propen-1-ol, 1-carboxy-3 methyl-2-propen-1-ol, 1-(2-carbethoxyisopropyl)-3-methyl-2-propen-1-ol, 1-(1-carbethoxypropyl)-2-propen-1-ol, 1-(1-carbethoxyethyl)-3-methyl-2-propen-1-ol, 1-carbethoxy-3-chloro-3-methyl-2-propen-1-ol, 1-carbethoxymethylene-3-methyl-2-propen-1-ol, 1-amido-2,3-dimethyl-2-propen-1-ol, 1-cyano-3-methyl-2-propen-1-ol, 3-sulfo-2-propen-1-ol, 3-butoxy-2-propen-1-ol, 1-cyclohexyl-3-(2-hydroxycyclohexyl)-2-propen-1-ol, 3-cyclobenzyl-2-propen-1-ol, 3-furyl-2-propen-1-ol, 3-chloro-2-propen-1-ol, 3-bromo-2-propen-1-ol, 2-methyl-3-chloro-2-propen-1-ol, 2-methyl-3-bromo-2-propen-1-ol, 1-carboisobutoxy-3-chloro-3-methyl-2-propen-1-ol, 2-chloro-3-phenyl-2-propen-1-ol (2-chlorocinnamyl alcohol), 2-bromo-3-phenyl-2-propen-1-ol (2-bromocinnamyl alcohol), 2-bromo-3-(4-nitrophenyl)-2-propen-1-ol, 2-fluoro-3-phenyl-2-propen-1-ol (2-fluorocinnamyl alcohol), 2-fluoro-3-(4-methoxyphenyl)-2-propen-1-ol, 2-nitro-3-chloro-3-phenyl-2-propen-1-ol, 2-nitro-3-phenyl-2-propen-1-ol (2-nitrocinnamyl alcohol), 2-cyano-3-phenyl-2-propen-1-ol (2-cyanocinnmaryl alcohol), 2-chloro-2-propen-1-ol (2-chloroallyl alcohol), 2-bromo-2-propen-1-ol (2-bromoallyl alcohol), 2-carboxy-2-propen-1-ol (2-carboxyallyl alcohol), 2-carbethoxy-2-propen-1-ol (2-carbethoxyallyl alcohol), 2-sulfonic acid-2-propen-1-ol (2-sulfonic acid-allyl alcohol), 2-nitro-2-propen-1-ol (2-nitroallyl alcohol), 2-bromo-3,3-difluoro-2-propen-1-ol, 2-chloro-3,3-difluoro-2-propen-1-ol, 2-fluoro-3-chloro-2-propen-1-ol, 2,3-dibromo-3-carboxy-2-propen-1-ol, 2,3-diiodo-3-carboxy-2-propen-1-ol, 2,3-dibromo-2-propen-1-ol, and 2-chloro-3-methyl-2-propen-1-ol.

Needless to say, compounds obtained by replacing the alcohol in the position 1 of the above-mentioned specific examples by a thioalcohol, amine, or halogen can also be used.

The contained amounts of the crosslinkable groups in the polymer are 10 to 90 mol % and 5 to 60 mol %, and are preferably 20 to 70 mol % and 10 to 40 mol %, respectively, in copolymerized molar ratios.

Also usable are acidic cellulosic derivatives having in the side chain thereof a carboxyl group. In addition, also useful are polymers obtained by adding a cyclic acid anhydride to an addition polymer having a hydroxyl group. Among these polymers, suitable are a copolymer formed from [benzyl (meth)acrylate/(meth)acrylic acid/optionally an addition-polymerizable vinyl monomer] and a copolymer made up of [allyl (meth)acrylate/(meth)acrylic acid/optionally an addition-polymerizable vinyl monomer]. Besides these polymers, polyvinyl pyrrolidone, polyethylene oxide, and the like are usefull as water-soluble organic polymers. In addition, in order to enhance the strength of the hardened film, an alcohol-soluble polyamide, a polyether of 2,2-bis-(4-hydroxyphenyl) -propane and epichlorohydrin, and the like are useful. Although any amount of these organic polymers may be included in the composition, an amount exceeding 90% by weight adversely affects the strength and other properties of images to be formed. The amount is preferably 10 to 90% and more preferably 30 to 80%. The weight ratios of the photopolymerizable ethylenically unsaturated compound to the organic polymer fall preferably within a range of 1/9 to 9/1, more preferably within a range of 2/8 to 8/2, and even more preferably within a range of 3/7 to 7/3.

In the present invention, in addtion to the above-described fundamental components, it is preferable to add a small amount of a thermal polymerization inhibitor in order to inhibit unnecessary thermal polymerization of the photopolymerizable ethylenically unsaturated compound while the photosensitive composition to be included in photopolymerizable photosensitive layer is produced or stored. Examples of a suitable thermal polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), a primary cerium salt of N-nitrosophenylhydroxyl amine, an aluminum salt of N-nitrosophenylhydroxyl amine, and the like. The amount to be added of the thermal polymerization inhibitor is about 0.01 to about 5% based on the weight of the entire composition. If necessary, in order to prevent polymerization inhibition due to oxygen, a higher fatty acid derivative, such as behenic acid or a behenic acid amide, may be added so that the higher fatty acid derivative is localized in the surface of the photosensitive layer in the process of drying after the application of the composition. The amount of the higher fatty acid derivative to be added is preferably about 0.5 to about 10% based on the entire composition.

In addition, for the purpose of the coloration of the photosensitive layer, a coloring agent may be added. Examples of the coloring agent include pigments such as phthalocyanine based pigments (C. I. Pigment Blue 15:3, 15:4, 15:6, and so on), azo dyes, carbon black, and titanium oxide, and dyes such as ethyl violet, crystal violet, azo dyes, anthraquinone dyes, and cyanine dyes. The amount to be added of the dye or pigment is preferably about 0.5 to about 20% based on the amount of the entire composition.

Furthermore, in order to improve the physical properties of the hardened film, additives such as an inorganic filler or a plasticizer such as dioctyl phthalate, dimethyl phthalate, tricresyl phosphate, or the like may be added.

The amount to be added of these additives is preferably 10% or less based on the entire composition.

When the photopolymerizable composition is coated on a support, a solution prepared by dissolving the photopolymerizable composition in an organic solvent is used. Examples of the solvent to be used for this purpose include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol monoethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butylolactone, methyl lactate, ethyl lactate, and the like. These solvents may be used singly or in combinations. A

suitable concentration of the solid components in the coating solution is 1 to 50% by weight.

In order to improve the quality of the coated layer of the photopolymerizable composition of the present invention, a surfactant may be incorporated into the composition.

The coated amount of the composition after coating and drying is preferably about 0.1 to about 10 $g/m^2$, more preferably 0.3 to 5 $g/m^2$, and even more preferably 0.5 to 3 $g/m^2$.

[Overcoat layer]

The overcoat layer of the present invention is an overcoat layer oxygen-impermeable, and this overcoat layer contains a water-soluble vinyl polymer. Examples of the water-soluble vinyl polymer to be incorporated into the overcoat layer include polyvinyl alcohol, a partial ester, ether, or acetal thereof, and a copolymer thereof containing unsubstituted vinyl alcohol units in a substantial amount necessary for making the copolymer water-soluble. An example of the polyvinyl alcohol is a 71 to 100% hydrolyzed polyvinyl alcohol having a degree of polymerization of 300 to 2400. Specific examples of the polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217EE, PVA-220E, PVA-224, PVA-405, PVA-420, PVA-613, L-8, and others, all of which are manufactured by Kuraray Co., Ltd. Examples of the copolymer include 88 to 100% hydrolyzed polyvinyl acetate chloroacetate or propionate, polyvinyl formal, polyvinyl acetal, and copolymers thereof. Examples of other useful polymers include polyvinyl pyrrolidone, gelatin, and gum arabic. These may be used singly or in combinations.

Although the preferred solvent to be used when applying the overcoat layer is pure water, a mixture of pure water and an alcohol, such as methanol or ethanol, or a ketone, such as acetone or methyl ethyl ketone, may be used. The suitable concentration of the solid components in the coating solution is 1 to 20% by weight.

Conventionally known additives, such as a surfactant for the enhancement of coatability and a water-soluble plasticizer for the improvement of the physical properties of the film, may be included in the overcoat layer. Examples of the water-soluble plasticizer include propionamide, cyclohexanediol, glycerin, and sorbitol. A water-soluble (meth) acrylic polymer or the like may also be included in the overcoat layer.

The coated amount of the overcoat layer after drying is preferably about 0.1 to about 15 $g/m^2$ and more preferably 1.0 to about 5.0 $g/m^2$.

For the sake of explanation, in the present embodiment, one personal computer is connected on-line to the work station 12. However, it goes without saying that the number of personal computers is not limited to one and a plurality of personal computers may be connected on-line to the work station 12. Likewise, for the sake of explanation, one PS plate processor 16 is connected on-line to the plate setter 14 in the present embodiment. However, needless to say, the number of PS plate processors is not limited to one and one or a plurality of personal computers may be connected on-line to the plate setter 14.

In the case where a plurality of personal computers are connected on-line to the plate setter 14, operation becomes more efficient due to diminished loss time because the setting of conditions at times when, for example, the heating conditions change can be carried out more efficiently.

In the present embodiment, the image data to be outputted from the workstation is in the form of a TIFF file. However, needless to say, the present invention is not limited to TIFF files, and image data in standard formats including image data such as a GIF file or a PPF file, Which is formed by low-resolution image data, transfer characteristic curves of films and plates, data of types and positions of register marks, color density information for quality control, and information about cutting register marks and cutting, or the like, can also be used.

The plate setter 14 is connected on-line to the PS plate processor 16 in the present embodiment. However, the present invention is not limited to such on-line connection. Therefore, the connection may be made via a telecommunication line. Alternatively, the setter information may be transferred by storing the information of the plate setter 14 as setter information in a storage medium and by the PS plate processor 16 reading the storage medium.

In the present embodiment, the ROM stores a table of a standard heating capacities in corresponding to combinations of plate types, plate thicknesses, and plate sizes. However, the ROM may store at least one of a table of a standard heating capacities in corresponding to plate type, a table of standard heating capacities corresponding to plate thicknesses, and a table of standard heating capacities corresponding plate sizes so that a standard heating capacity is determined based on the stored table.

For example, when a halogen lamp heater, which is provided with black coating and has a diameter of 2.50 mm, is used as the heating device 32 and the PS plate 110 is transferred at 19 mm/sec, as a table of standard heating capacities corresponding to plate thicknesses, a table is used in which the driving voltage increases as the aluminum support becomes thicker in accordance with the plate thickness, in such a way that the driving voltage for a plate thickness of 0.15 mm is 98V, the driving voltage for a plate thickness of 0.24 mm is 137V, the driving voltage for a plate thickness of 0.3 mm is 165V, and the driving voltage for a plate thickness of 0.4 mm is 200V.

In the present embodiment, although the replenisher solution amount determining program is stored in the

ROM of the processor controlling section 30, the present invention is not limited to the same. The replenisher solution amount determining program may be stored in the ROM of the setter controlling section 18 or in the ROM of a personal computer of the preceding step.

Alternatively, the replenisher solution amount determining program may be stored in a floppy disk and the computer main body may be provided with a hard disk so that the replenisher solution amount determining program is read from the floppy disk and installed in the hard disk. Or, the replenisher solution amount determining program may be transmitted to a wired or wireless network by a transmitting means such as a telephone line and installed therein.

The storage of the replenisher solution amount determining program is not limited to storage on a floppy disk. Instead, the replenisher solution amount determining program may be stored on a CD-ROM or a magnetic tape, so that the replenisher solution amount determining program is installed from the CD-ROM or magnetic tape into the hard disk of a personal computer. Alternatively, a hard disk which stores the replenisher solution amount determining program may be provided. The replenisher solution amount determining program may be directly written into the hard disk or the RAM of a personal computer. As described above, the replenisher solution amount determining program can be distributed by at least one of a tangible storage medium and a transmitting means.

Although the undiluted development replenisher solution and the dilution water are supplied separately to the developing tank in the above-described explanation, the undiluted development replenisher solution and the dilution water may be mixed in a mixing tank and the mixture solution then supplied to the developing tank.

In the present embodiment, the surface area of non-image formed portions can be calculated from the low-resolution data included in the PPF data, thus enabling high-speed calculation. Another advantage of the present embodiment is that, since there is not a large amount of data and therefore a relatively cheap CPU can be used, the cost of the apparatus is reduced accordingly.

It goes without saying that the present invention is not limited to the structure in which the surface area of non-image formed portions is calculated from the low-resolution data included in the PPF data. Other possible structures include a structure in which the surface area of non-image formed portions is calculated by multiplying the number zero (representing the surface area of non-image formed portions in image data in bitmap form), by the surface area occupied by one pixel forming the bitmap, and a structure in which the area information of images is calculated by use of a conventionally known surface area calculating program.

In the present embodiment, a program for calculating the surface area of non-image formed portions is stored in the processor controlling section 30 of the PS plate processor 16, and the area information of images is calculated in the processor controlling section 30. However, the program for calculating the surface area of non-image formed portions may be stored in the personal computer 10 or in the workstation 12 as an independent program or as a program incorporated into a software such as a software for disposing the printing plate such that the same page or the same surface can be printed plural times on a single sheet for printing, or such that printing can be carried out with the pages in their correct order, and the calculated surface area of non-image formed portions may be fetched on-line or off-line.

As described above, according to the present invention, the active state of the developing solution, which is filled in the developing tank for planographic plates, can be maintained at a constant level in accordance with the state of consumption of the developing solution being used for development processing.

## Claims

1. A process for image formation on a planographic plate, the process comprising the steps of:

    (a) exposing a planographic plate, having a photopolymerizable photosensitive layer, in accordance with image data;
    (b) developing the planographic plate by introducing the planographic plate into a developing tank;
    (c) determining an amount of replenisher solution to be supplied to the developing tank based on area information of images formed or to be formed and plate information; and
    (d) supplying replenisher solution to the developing tank in an amount in accordance with the step of determining an amount of replenisher solution, wherein the area information of the images formed or to be formed comprises at least one of image data to be used in the step of exposing a planographic plate, and low-resolution image data included in Print Production Format data.

2. The process of Claim 1, wherein the plate information and the area information of the formed images or the images to be formed are information which was obtained or inputted on-line or off-line from a step before the developing step.

3. The process of Claim 1 or 2, wherein the step of determining an amount of replenisher solution includes determining

at least part of the replenisher solution amount by the sub-steps of:

(a) calculating an area of non-image formed portions by subtracting an area of image formed portions based on plate area information, from an area of image formable portions based on a plate size which is included in plate information;
(b) determining a replenisher solution amount required per unit area, on the basis of at least one of plate thickness and plate type which are included in the plate information;
(c) multiplying the area of the non-image formed portions by the replenisher solution amount required per unit area.

**4.** The process of Claim 3, wherein the process is for use with a plurality of planographic plates and the step of supplying replenisher solution is not performed if the amount of replenisher solution to be supplied does not exceed a predetermined amount, and the amount to be supplied is cumulative, based on whether the step of supplying replenisher solution has not been performed for a previous planographic plate.

**5.** The process of any of Claims 1 to 4, further comprising the step of selecting concentrations for developing solution and replenisher solution based on plate type for determining dilution ratio of the replenisher solution by the concentrations.

**6.** The process of any of Claims 1 to 5, wherein the photopolymerizable photosensitive layer contains a compound containing an ethylenic double bond capable of addition polymerization, a photopolymerization initiator, and an organic polymer binder.

**7.** A computer-readable recording medium for use by a computer in controlling a development process according to any one of claims 1 to 6 using an automatic developing apparatus for automatically developing an exposed planographic plate having a photopolymerizable photosensitive layer, by means of the process defined in any one of claims 1 to 6, by using developing solution and the replenisher solution, the apparatus comprising:

(a) a developing section for receiving an exposed planographic plate, the developing section having a developing tank for containing developing solution, and a conveying device which conveys the planographic plate in the developing solution;
(b) a nozzle system connected to a supply of replenisher solution, electronically operable for supplying replenisher solution into the developing tank; and
(c) a control system electronically connected to the nozzle system, the control system including a memory and an electronic logic, the electronic logic causing operation of the nozzle system to supply replenisher solution into the developing tank based on area information of images formed or to be formed and plate information in the control system memory,

said computer-readable recording medium comprising electronically readable logic encoded thereon, which when used in the computer, causes the computer to:

(a) determine an amount of replenisher solution to be supplied to the developing tank based on area information of images formed or to be formed on a planographic plate and plate information; and
(b) activate the electronic control system to supply replenisher solution to the developing tank in an amount in accordance with the determined amount of replenisher solution.

**Patentansprüche**

**1.** Verfahren zur Bildgebung auf einer planografischen Platte, wobei das Verfahren die folgenden Schritte umfasst:

(a) Belichtung einer planografischen Platte, die eine fotopolymerisierbare lichtempfindliche Schicht aufweist, gemäß den Bilddaten;

(b) Entwicklung der planografischen Platte durch Einführen der planografischen Platte in einen Entwicklertank;

(c) Bestimmung der Menge an dem Entwicklertank zuzuführender Nachfülllösung ("Replenisher Solution"), basierend auf Flächeninformationen zu den gebildeten oder zu bildenden Bildern sowie Platteninformationen;

und

(d) Zuführen der Nachfülllösung zu dem Entwicklertank in einer Menge gemäß dem Schritt der Bestimmung der Menge der Nachfülllösung, worin die Flächeninformationen zu den gebildeten oder zu bildenden Bildern zumindest eines aus den im Schritt der Belichtung der planografischen Platte zu verwendenden Bilddaten, und niedrig aufgelösten Bilddaten umfassend Bildproduktionsformatdaten ("Print Production Format Data") umfasst.

**2.** Das Verfahren nach Anspruch 1, worin die Platteninformation und die Flächeninformation zu den gebildeten Bildern oder den zu bildenden Bildern Informationen sind, die on-line oder off-line erhalten oder eingegeben wurden aus einem Schritt vor dem Entwicklungsschritt.

**3.** Das Verfahren gemäß Anspruch 1 oder 2, worin der Schritt der Bestimmung der Menge an Nachfülllösung die Bestimmung von zumindest einem Teil der Menge der Nachfülllösung mittels der folgenden Unterschritte umfasst:

(a) Berechnung der Fläche der Bereiche ohne Bildgebung durch Subtraktion der Fläche der Bildbereiche, basierend auf Plattenflächeninformationen, von der Fläche, in der Bildbereiche gebildet werden können, basierend auf der Plattengröße, welche in der Platteninformation beinhaltet ist;

(b) Bestimmung der erforderlichen Menge an Nachfülllösung pro Flächeneinheit, basierend auf zumindest einem von der Plattendicke und dem Plattentyp, welche in der Platteninformation beinhaltet sind;

(c) Multiplizierung der Fläche der nicht bildformenden Bereiche mit der pro Flächeneinheit erforderlichen Menge an Nachfülllösung.

**4.** Das Verfahren nach Anspruch 3, worin das Verfahren zur Verwendung bei einer Vielzahl von planografischen Platten ist und der Schritt der Zuführung von Nachfülllösung nicht durchgeführt wird, wenn die zuzuführende Menge an Nachfülllösung nicht eine vorbestimmte Menge überschreitet, und die zuzuführende Menge kumulativ ist, sofern der Schritt der Zuführung von Nachfülllösung nicht durchgeführt wurde für eine vorherige planografische Platte.

**5.** Das Verfahren nach irgendeinem der Ansprüche 1 bis 4, weiterhin umfassend den Schritt der Auswahl von Konzentrationen für die Entwicklerlösung und die Nachfülllösung, basierend auf dem Plattentyp zur Bestimmung des Verdünnungsverhältnisses der Nachfülllösung durch die Konzentrationen.

**6.** Das Verfahren nach irgendeinem der Ansprüche 1 bis 5, worin die fotopolymerisierbare lichtempfindliche Schicht eine Verbindung umfasst, enthaltend eine ethylenische Doppelbindung, die geeignet ist zur Additionspolymerisation, einen Fotopolymerisationsinitiator und ein organisches Polymerbindemittel.

**7.** Computerlesbares Aufzeichnungsmedium zur Verwendung durch einen Computer bei der Kontrolle eines Entwicklungsverfahrens gemäß irgendeinem der Ansprüche 1 bis 6 unter Verwendung eines automatischen Entwicklungsapparates zur automatischen Entwicklung einer belichteten planografischen Platte mit einer fotopolymierisierbaren lichtempfindlichen Schicht, durch das Verfahren, welches in irgendeinem der Ansprüche 1 bis 6 definiert ist, unter Verwendung einer Entwicklerlösung und der Nachfülllösung, wobei der Apparat umfasst:

(a) einen Entwicklerbereich zur Aufnahme einer belichteten planografischen Platte, wobei der Entwicklerbereich einen Entwicklertank für Entwicklerlösung aufweist, sowie eine Fördervorrichtung, welche die planografische Platte in die Entwicklerlösung befördert;

(b) ein Düsensystem verbunden mit der Zuführung von Nachfülllösung, elektronisch bedienbar für die Zuführung von Nachfülllösung in den Entwicklertank; und

(c) ein elektronisch mit dem Düsensystem verbundenes Kontrollsystem, wobei das Kontrollsystem eine Speicher und eine elektronische Logik umfasst, wobei die elektronische Logik die Operation des Düsensystems verursacht unter Zuführung von Nachfülllösung in den Entwicklertank, basierend auf Flächeninformationen der gebildeten oder zu bildenden Bilder und Platteninformationen im Speicher des Kontrollsystems, wobei besagtes computerlesbares Aufzeichnungsmedium elektronisch lesbare darauf codierte logische Daten umfasst, welche bei Verwendung in dem Computer den Computer dazu veranlassen:

(a) die Menge an dem Entwicklertank zuzuführender Nachfülllösung zu bestimmen, basierend auf Flächeninformation der gebildeten oder zu bildenden Bilder auf der planografischen Platte und Platteninformationen; und

(b) das elektronische Kontrollsystem zu aktivieren, Nachfülllösung zu dem Entwicklertank in einer Menge zuzuführen gemäß der bestimmten Menge an Nachfülllösung.

**Revendications**

1. Procédé pour formation d'image sur une plaque planographique, le procédé comprenant les étapes de :

   (a) exposer une plaque planographique, ayant une couche photosensible photopolymérisable, selon les données d'image ;
   (b) développer la plaque planographique en introduisant la plaque planographique dans un réservoir de développement ;
   (c) déterminer une quantité de solution d'entretien qui est fournie au réservoir de développement sur la base d'information de zone d'images formées ou devant être formées et d'information de plaque ; et
   (d) fournir une solution d'entretien au réservoir de développement en une quantité en accord avec l'étape de détermination de la quantité de solution d'entretien, dans lequel l'information de zone des images formées ou devant être formées comprend au moins une des données d'image qui est utilisée dans l'étape d'exposition d'une plaque planographique, et des données d'image à basse résolution inclues dans des données de Format de Production d'Impression.

2. Procédé de la revendication 1, dans lequel l'information de plaque et l'information de zone des images formées ou des images qui doivent être formées sont des informations qui ont été obtenues ou entrées en-ligne ou hors-ligne à partir d'une étape avant l'étape de développement.

3. Procédé de la revendication 1 ou 2, dans lequel l'étape de déterminer une quantité de solution d'entretien inclut de déterminer au moins une partie de la quantité de la solution d'entretien par les sous-étapes de :

   (a) calculer une zone de parties d'image non-formées en soustrayant une zone de parties d'images formées sur la base d'information de zone de plaque, d'une zone de parties d'images susceptibles d'être formées sur la base d'une taille de plaque qui est inclue dans de l'information de plaque ;
   (b) déterminer une quantité de solution d'entretien requise par zone unitaire, sur la base d'au moins l'un de l'épaisseur de plaque et du type de plaque qui sont inclus dans l'information de plaque ;
   (C) multiplier la zone des parties d'image non-formées par la quantité de solution d'entretien requise par zone unitaire.

4. Procédé de la revendication 3, dans lequel le procédé est pour une utilisation avec une pluralité de plaques planographiques et l'étape de fournir une solution d'entretien n'est pas effectuée si la quantité de solution d'entretien qui est fournie n'excède pas une quantité prédéterminée, et la quantité qui est fournie est cumulative, sur la base de si l'étape de fournir une solution d'entretien n'a pas été effectuée pour une plaque planographique antérieure.

5. Procédé de l'une quelconque des revendications 1 à 4, comprenant en plus l'étape de choisir des concentrations pour une solution de développement et une solution d'entretien sur la base d'un type de plaque pour déterminer un rapport de dilution de la solution d'entretien par les concentrations.

6. Procédé de l'une quelconque des revendications 1 à 5, dans lequel la couche photosensible photopolymérisable contient un composé contenant une double liaison éthylénique capable d'une polymérisation par addition, un initiateur de photopolymérisation, et un liant de polymère organique.

7. Support d'enregistrement lisible par ordinateur pour une utilisation par un ordinateur pour contrôler un procédé de développement selon l'une quelconque des revendications 1 à 6 en utilisant un dispositif de développement automatique afin de développer automatiquement une plaque planographique exposée ayant une couche photosensible photopolymérisable, au moyen du procédé défini dans l'une quelconque des revendications 1 à 6, en utilisant une solution de développement et la solution d'entretien, le dispositif comprenant :

(a) une section de développement pour recevoir une plaque planographique exposée, la section de développement ayant un réservoir de développement pour contenir une solution de développement, et un dispositif de transport qui transporte la plaque planographique dans la solution de développement ;
(b) un système de buses connecté à une alimentation de solution d'entretien, susceptible d'être mis en fonctionnement électroniquement pour fournir une solution d'entretien dans le réservoir de développement ; et
(c) un système de commande électroniquement connecté au système de buses, le système de commande incluant une mémoire et une logique électronique, la logique électronique provoquant le fonctionnement du système de buses afin de fournir une solution d'entretien dans le réservoir de développement sur la base d'une information de zone d'images formées ou devant être formées et une information de plaque dans la mémoire du système de contrôle, ledit support d'enregistrement lisible par ordinateur comprenant une logique lisible électroniquement codée sur celui-ci, qui lorsque utilisée dans l'ordinateur, contraint l'ordinateur à :

(a) déterminer une quantité de solution d'entretien devant être fournie au réservoir de développement sur la base d'une information de zone d'images formées ou devant être formées sur une plaque planographique et d'une information de plaque ; et
(b) activer le système de commande électronique afin de fournir la solution d'entretien au réservoir de développement en une quantité en accord avec la quantité déterminée de solution d'entretien.

FIG. 1

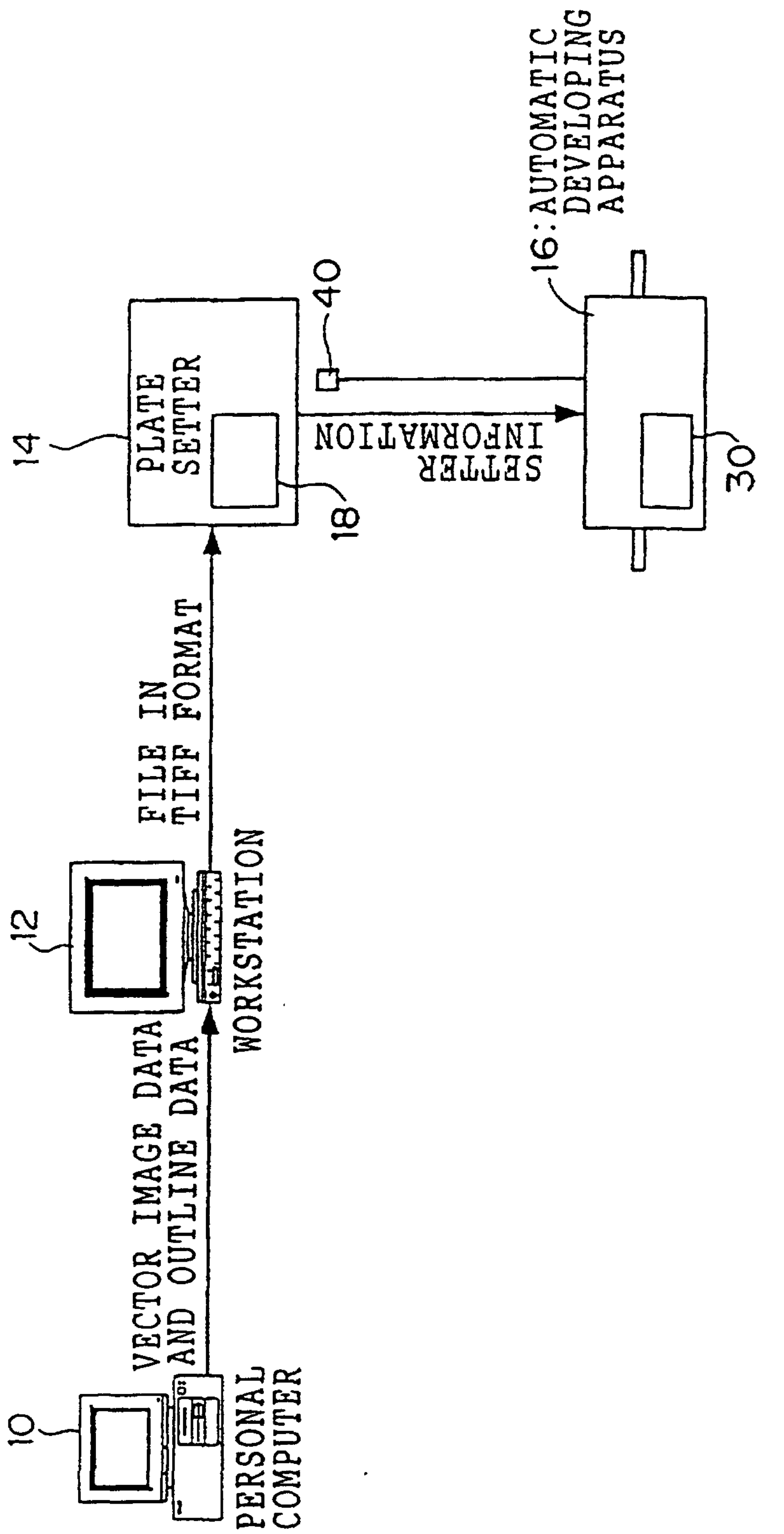
10
PERSONAL COMPUTER
VECTOR IMAGE DATA AND OUTLINE DATA
12
WORKSTATION
FILE IN TIFF FORMAT
14
PLATE SETTER
18
40
SETTER INFORMATION
16: AUTOMATIC DEVELOPING APPARATUS
30

FIG. 2

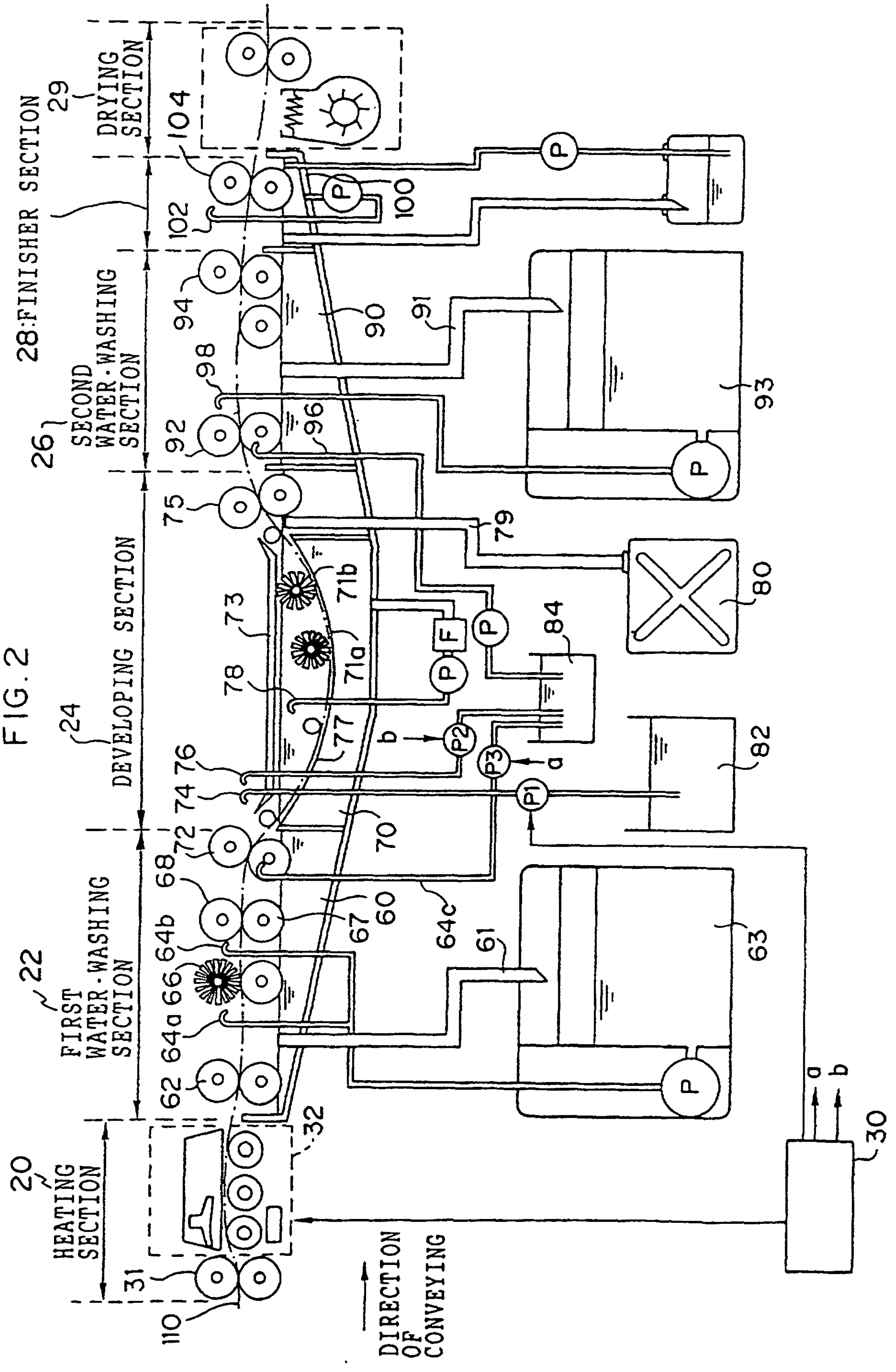
HEATING SECTION
FIRST WATER·WASHING SECTION
DEVELOPING SECTION
SECOND WATER·WASHING SECTION
28:FINISHER SECTION
DRYING SECTION
DIRECTION OF CONVEYING

FIG.3

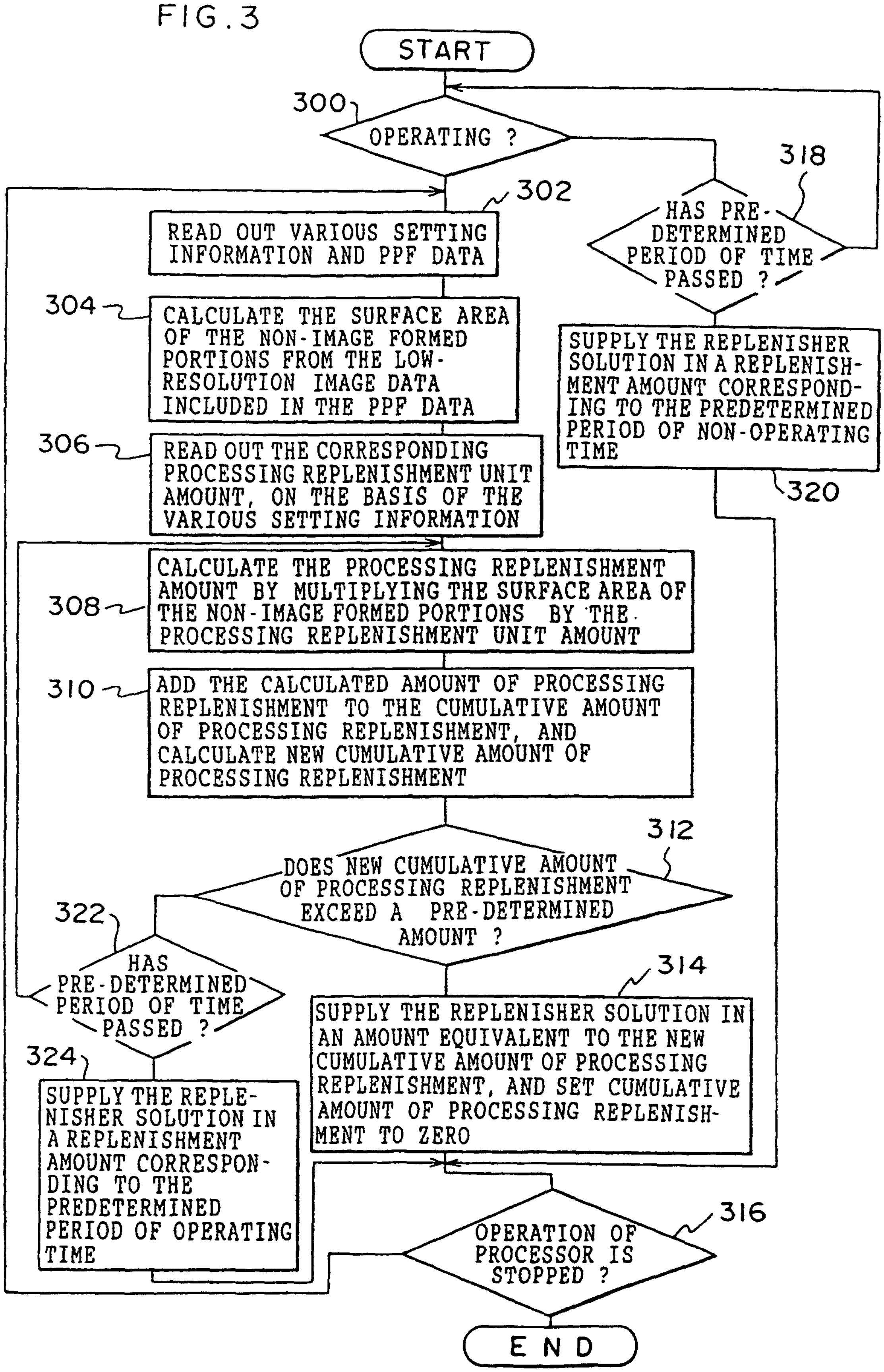
START
300
OPERATING ?
302
READ OUT VARIOUS SETTING INFORMATION AND PPF DATA
304
CALCULATE THE SURFACE AREA OF THE NON-IMAGE FORMED PORTIONS FROM THE LOW-RESOLUTION IMAGE DATA INCLUDED IN THE PPF DATA
306
READ OUT THE CORRESPONDING PROCESSING REPLENISHMENT UNIT AMOUNT, ON THE BASIS OF THE VARIOUS SETTING INFORMATION
308
CALCULATE THE PROCESSING REPLENISHMENT AMOUNT BY MULTIPLYING THE SURFACE AREA OF THE NON-IMAGE FORMED PORTIONS BY THE PROCESSING REPLENISHMENT UNIT AMOUNT
310
ADD THE CALCULATED AMOUNT OF PROCESSING REPLENISHMENT TO THE CUMULATIVE AMOUNT OF PROCESSING REPLENISHMENT, AND CALCULATE NEW CUMULATIVE AMOUNT OF PROCESSING REPLENISHMENT
312
DOES NEW CUMULATIVE AMOUNT OF PROCESSING REPLENISHMENT EXCEED A PRE-DETERMINED AMOUNT ?
314
SUPPLY THE REPLENISHER SOLUTION IN AN AMOUNT EQUIVALENT TO THE NEW CUMULATIVE AMOUNT OF PROCESSING REPLENISHMENT, AND SET CUMULATIVE AMOUNT OF PROCESSING REPLENISHMENT TO ZERO
316
OPERATION OF PROCESSOR IS STOPPED ?
END
318
HAS PRE-DETERMINED PERIOD OF TIME PASSED ?
320
SUPPLY THE REPLENISHER SOLUTION IN A REPLENISHMENT AMOUNT CORRESPONDING TO THE PREDETERMINED PERIOD OF NON-OPERATING TIME
322
HAS PRE-DETERMINED PERIOD OF TIME PASSED ?
324
SUPPLY THE REPLENISHER SOLUTION IN A REPLENISHMENT AMOUNT CORRESPONDING TO THE PREDETERMINED PERIOD OF OPERATING TIME